(19) Europäisches Patentamt
European Patent Office
Office européen des brevets

(11) EP 3 918 356 B1

(12) EUROPÄISCHE PATENTSCHRIFT

(45) Veröffentlichungstag und Bekanntmachung des Hinweises auf die Patenterteilung:
07.12.2022 Patentblatt 2022/49

(21) Anmeldenummer: 20703957.9

(22) Anmeldetag: 31.01.2020

(51) Internationale Patentklassifikation (IPC):
$G01R\ 33/00^{(2006.01)}$ $G01R\ 33/09^{(2006.01)}$

(52) Gemeinsame Patentklassifikation (CPC):
G01R 33/0052; G01R 33/093; G01R 33/098; G01R 33/007

(86) Internationale Anmeldenummer:
PCT/EP2020/052461

(87) Internationale Veröffentlichungsnummer:
WO 2020/157293 (06.08.2020 Gazette 2020/32)

(54) **ANORDNUNG BENACHBARTER SCHICHTSTRUKTUREN FÜR EINEN MAGNETORESISTIVEN MAGNETFELDSENSOR, MAGNETORESISTIVER MAGNETFELDSENSOR UND VERFAHREN ZU DEREN HERSTELLUNG**

ARRANGEMENT OF ADJACENT LAYER STRUCTURES FOR A MAGNETORESISTIVE MAGNETIC FIELD SENSOR, MAGNETORESISTIVE MAGNETIC FIELD SENSOR AND METHOD FOR PRODUCING SAME

ENSEMBLE DE STRUCTURES STRATIFIÉES ADJACENTES POUR UN CAPTEUR DE CHAMP MAGNÉTIQUE MAGNÉTORÉSISTIF, CAPTEUR DE CHAMP MAGNÉTIQUE MAGNÉTORÉSISTIF ET PROCÉDÉ POUR LEUR FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.02.2019 DE 102019102618**
**26.03.2019 DE 102019107689**

(43) Veröffentlichungstag der Anmeldung:
**08.12.2021 Patentblatt 2021/49**

(73) Patentinhaber: Sensitec GmbH
**35578 Wetzlar (DE)**

(72) Erfinder:
• **WAHRHUSEN, Jürgen**
  **55437 Nieder-Hilbersheim (DE)**
• **PAUL, Johannes**
  **55128 Mainz (DE)**

(74) Vertreter: **Spachmann, Holger**
**Stumpf Patentanwälte PartGmbB**
**Alte Weinsteige 73**
**70597 Stuttgart (DE)**

(56) Entgegenhaltungen:
EP-A1- 3 091 364      EP-A1- 3 285 041
WO-A1-2016/078793     US-A1- 2008 232 003
US-A1- 2013 265 039

• FREITAS PAULO P ET AL: "Spintronic Sensors", PROCEEDINGS OF THE IEEE, IEEE. NEW YORK, US, vol. 104, no. 10, 1 October 2016 (2016-10-01), pages 1894-1918, XP011623648, ISSN: 0018-9219, DOI: 10.1109/JPROC.2016.2578303 [retrieved on 2016-09-19]

EP 3 918 356 B1

**Beschreibung**

Die vorliegende Erfindung betrifft eine Anordnung benachbarter Schichtstrukturen für einen magnetoresistiven Magnetfeldsensor, zumindest umfassend eine antiferromagnetische Schicht, eine erste ferromagnetische Schicht mit einem ersten magnetischen Moment, wobei zwischen der antiferromagnetischen Schicht und der ersten ferromagnetischen Schicht eine Austauschkopplung besteht, und eine zweite ferromagnetische Schicht mit einem zweiten magnetischen Moment, wobei die zweite ferromagnetische Schicht über eine zwischen der ersten und der zweiten ferromagnetischen Schicht angeordneten nichtmagnetischen Kopplungsschicht mit der ersten ferromagnetischen Schicht antiparallel gekoppelt ist.

Die Erfindung betrifft weiterhin einen magnetoresistiven Magnetfeldsensor mit einer derartigen Anordnung von Schichtstrukturen sowie Verfahren zum Herstellen der Anordnung von Schichtstrukturen und des magnetoresistiven Magnetfeldsensors.

STAND DER TECHNIK

Magnetoresistive Magnetfeldsensoren dienen der widerstandsbasierten Messung von Magnetfeldern. Durch geeignete geometrische Anordnungen können weitere physikalische Größen wie beispielsweise Weg, Winkel oder Stromstärke erfasst werden. Magnetoresistive Magnetfeldsensoren beruhen auf einem magnetoresistiven Effekt. Dieser beschreibt eine Änderung des elektrischen Widerstands eines Materials durch Anlegen oder Verändern eines äußeren Magnetfelds. Magnetfeldsensoren mit einem vergleichsweise hohen magnetoresistiven Effekt, welcher durch den Quotienten aus Widerstandsänderung ($\Delta R = R_{Max} - R_{Min}$) und dem minimalen Widerstand $R_{Min}$ beschrieben werden kann, basieren auf dem Riesenmagnetowiderstandseffekt (GMR-Effekt, von Englisch giant magnetoresistance) oder dem Tunnelmagnetoeffekt (TMR-Effekt, von Englisch tunnel magnetoresistance). Alternativ stehen Materialien zur Verfügung, die den AMR Effekt (anisotropic magneto resistance) zeigen. Diese Effekte werden auch zusammenfassend als xMR-Effekt bezeichnet.

GMR- und TMR- Magnetfeldsensoren umfassen einen Dünnschichtaufbau von nichtmagnetischen und magnetischen Materialien, bei welchen eine magnetische Kopplung bzw. ein Spin-Effekt durch die Schichten hindurch einen Einfluss auf den elektrischen Widerstand hat. Bei GMR- und TMR-basierten magnetoresistiven Schichtstrukturen kann eine Veränderung des elektrischen Widerstandes auf Basis eines externen Magnetfeldes von bis zu 50% (GMR) bzw. bis zu 600% (TMR) erreicht werden.

Für die Herstellung von TMR-Magnetfeldsensoren wird ein Schichtaufbau von mindestens zwei ferromagnetischen Schichten und einer elektrisch isolierenden Barriereschicht, die als Tunnelbarriere dient und auch als Zwischenschicht bezeichnet wird, ausgebildet, sodass zwischen den beiden ferromagnetischen Schichten ein Tunnelstrom fließen kann. Im Falle eines TMR-Magnetfeldsensors besteht die Barriereschicht beispielsweise aus $Al_2O_3$ oder MgO. Im Falle eines GMR-Magnetfeldsensors wird oft eine dünne nichtmagnetische, jedoch leitfähige Schicht aus Cu oder Ru verwendet. Der elektrische Widerstand eines Tunnelelements hängt neben geometrischen Parameter wie die Fläche davon ab, wie die beiden ferromagnetischen Schichten zueinander magnetisiert sind. Sind die beiden ferromagnetischen Schichten parallel zueinander magnetisiert, ist der Widerstand $R_{Min}$ minimal. Sind sie hingegen antiparallel zueinander magnetisiert, ist der Widerstand $R_{Max}$ maximal.

In der Praxis wird häufig die Magnetisierungsrichtung einer der beiden ferromagnetischen Schichten fixiert oder gepinnt, sodass die Magnetisierung dieser Schicht nicht oder nur schwach auf äußere Felder reagiert. Diese Schicht wird als Referenzschicht oder auch gepinnte Schicht bezeichnet. Die andere Schicht wird dagegen so gestaltet, dass ihre Magnetisierung in definierter Weise dem äußeren Feld folgen kann. Diese Schicht wird auch Detektionsschicht oder freie Schicht genannt.

Durch die Aufteilung in eine Referenzschicht und eine Detektionsschicht, die unterschiedlich auf äußere Felder reagieren, gelingt es, Widerstandsänderungen bei Veränderung von äußeren Feldern zu erhalten und eine sensorische Vorrichtung zu realisieren. Die Widerstandsabhängigkeit korreliert mit dem Winkel zwischen der Magnetisierungsrichtung der Detektionsschicht, die auch als "free layer" bezeichnet wird und der Magnetisierungsrichtung der Referenzschicht, die auch als "pinned layer" bezeichnet wird.

Eine Schichtstruktur ist dabei eine Struktur, die in die eine Achse typischerweise senkrecht zur Substratoberfläche als eine Abfolge von dünnen Schichten beschrieben werden kann, in den anderen dazu orthogonalen Achsen eine geometrische Form besitzt.

Zur Herstellung derartiger Strukturen bzw. Widerstandselemente werden Dünnschichttechnologien eingesetzt. Im Rahmen des Herstellverfahrens kann die Richtung der Magnetisierung der Referenzschicht permanent eingestellt werden, was häufig als Pinning bezeichnet wird. Zum Pinnen der ferromagnetischen Schicht oder der Referenzschicht wird in der Regel die ferromagnetische Schicht an eine antiferromagnetische Nachbarschicht gekoppelt. Zum Einstellen der Magnetisierungsrichtung wird das Widerstandselement, d.h. die Schichtstruktur, über die sogenannte Blocking-Temperatur erhitzt, bei welcher die Austauschkopplung zwischen der antiferromagnetischen Schicht und der ferromagnetischen Schicht verschwindet, wobei in der Regel diese Temperatur niedriger ist als die Curie-Temperatur der ferromagnetischen Schichten. Nach Erreichen der gewünschten Temperatur oberhalb der Blocking-Temperatur und unterhalb der Curie-Temperatur werden die ferromagnetischen Schichten einem externen Pinningfeld ausgesetzt, wodurch diese Schichten in eine definierte Magnetisierungsrichtung gezwungen werden. Dazu ist es erforderlich, dass das angelegte Pinningfeld groß genug ist, die ferromagnetische Schicht vollständig parallel zum Pinningfeld auszurichten. Diese Magnetisierungsrichtung bleibt erhalten, wenn bei angelegtem Pinningfeld die Schichtstruktur wieder abgekühlt und die Blocking-Temperatur unterschritten wird.

In diesem Zusammenhang wird im Weiteren von einem Pinningfeld als einem lokal wirkenden Magnetfeld gesprochen, das in einer gewünschten Pinning-Richtung eine ferromagnetische Schicht der Schichtstruktur rechtwinklig zur Schichtenreihenfolge, d.h. tangential zur Substratoberfläche durchdringt und eine lokale magnetische Feldkomponente darstellt. Davon zu unterscheiden ist das sogenannte Vorbehandlungsmagnetfeld als globales Ausrichtungsmagnetfeld, aus dem durch Führung des Magnetfelds, z.B. durch ferromagnetische Strukturierungselemente als Flussführungselemente das Pinningfeld abgeleitet wird. Das globale Vorbehandlungsmagnetfeld ist in der Regel stärker und kann in einer anderen Richtung als das lokale Pinningfeld ausgerichtet sein.

Ein Nachteil eines derartigen Referenz-Schichtsystems mit nur einer ferromagnetischen Referenzschicht, welches auch als "simple spin valve (SSV)" bezeichnet wird, besteht in einer nur geringen thermischen Stabilität. Insbesondere besteht die Gefahr, dass in einer Anwendung durch Auftreten von hohen Temperaturen und Magnetfeldern die Pinningrichtung gedreht wird. Dieser Effekt bewirkt eine Drift im Verhalten eines Sensors, der diese Referenzschichten verwendet. Dabei gilt, je kleiner das magnetische Moment der Referenzschicht ist, desto schwächer können Magnetfelder einkoppeln und die Schicht drehen. Daher ist es hier günstig, die Schichtdicken der Referenzschicht klein zu halten, damit mögliche Drifts auch klein sind. Allerdings ist der magnetoresistive Effekt bei derartigen SSV-Strukturen vergleichsweise klein. Ein Vorteil besteht jedoch darin, dass zur Ausrichtung der Referenzschicht nur geringe magnetische Feldstärken erforderlich sind.

Bei einer verbesserten Referenz-Schichtstruktur wird zusätzlich zu einer ersten ferromagnetischen Schicht, die auf der antiferromagnetischen Schicht angeordnet ist, eine zweite ferromagnetische Schicht vorgesehen. Zwischen diesen beiden ferromagnetischen Schichten ist eine Kopplungsschicht vorgesehen, welche eine antiparallele, RKKY-Kopplung (Ruderman-Kittel-Kasuya-Yoshida-Wechselwirkung) zwischen den beiden ferromagnetischen Schichten bewirkt. Derartige Schichtstrukturen werden auch als "antiparallelly coupled pinned layer spin valve (APP-SV)" bezeichnet.

Da die magnetischen Momente der beiden ferromagnetischen Schichten typischerweise annähernd gleich groß sind und sich das magnetische Gesamtmoment der ferromagnetischen Schichten aufgrund der antiparallelen Ausrichtung zu annähernd Null aufhebt, verursachen externe Magnetfelder im Betrieb nur eine geringe Änderung der Magnetisierungsrichtung des Referenzschichtsystems, sodass ein derartiges balanciertes APP-SV auch bei höheren Temperaturen stabil ist. Im Vergleich mit einem SSV ist zudem der magnetoresistive Effekt eines APP-SV größer.

Ein wesentlicher Nachteil besteht jedoch darin, dass wegen der sich aufhebenden magnetischen Momente der beiden ferromagnetischen Schichten (magnetisches Gesamtmoment ungefähr Null) ein Pinnen dieser Schichtstruktur nur dann möglich ist, wenn die magnetische Flussdichte so groß ist, dass die RKKY-Kopplung zwischen den ferromagnetischen Schichten überwunden wird. Dazu sind magnetische Flussdichten von mehr als 1 T erforderlich. Dies erfordert einen hohen Aufwand für den Pinning-Prozess. Magnetfeldsensoren, bei denen mehrere Schichtstapel oder Widerstandselemente vorgesehen sind, welche eine unterschiedliche magnetische Ausrichtung aufweisen sollen, lassen sich gar nicht oder nur mit sehr hohem Aufwand herstellen.

Zum Einstellen von Pinningrichtungen ist es bekannt, selektiv räumlich begrenzte Bereiche eines Schichtstrukturen tragenden Substrats mittels selektiver Erwärmungsverfahren, insbesondere mittels Laser zu erhitzen, und ein externes Magnetfeld in eine gewünschte Richtung parallel zur Substratoberfläche zum Pinnen anzulegen. Hierdurch ist es möglich, lokal erhitzte Bereiche mit Schichtstrukturen in eine identische Richtung zu pinnen. Sollen verschiedene Pinningrichtungen auf einem Substrat hergestellt werden, so ist das Verfahren mehrmals mit verschiedenen externen Magnetfeldausrichtungen zu wiederholen, wobei es allerdings nicht möglich ist, räumlich nahe benachbarte Schichtstrukturen in verschiedene Richtungen zu pinnen. Andererseits werden für den Aufbau von üblichen richtungsselektiven Magnetfeldsensoren Schichtstrukturen benötigt, die verschiedene Vorzugsrichtungen haben und die denselben prozesstechnischen Eigenschaften unterliegen, somit ist ein Pinnen von Schichtstrukturen in unterschiedliche Richtungen bei eng benachbarten Schichtstrukturen wünschenswert.

Weiterhin ist das Laserpinning unter einer Sekunde nachteilhaft für antiferromagnetische Materialien, die während des Pinning Prozesses erst in die antiferromagnetische geordnete L1o Phase rekristallisieren können, wie z.B. PtMn oder NiMn. Die Rekristallisierungsprozess dauert typischerweise mehrere Stunden und ist mit lokalem Erhitzen durch Laserlicht in der Praxis nicht erreichbar.

Aus WO 2016/078793 A1 sind ein Verfahren und eine Vorrichtung zum multidirektionalen Pinnen von Magnetfeldsensoren bekannt, bei denen weichmagnetische Strukturierungselemente, d.h. Flussführungselemente benachbart zu den Schichtstrukturen angeordnet werden, welche ein Vorbehandlungsmagnetfeld in die Schichtstrukturen einkoppeln. Das dort vorgestellte Verfahren ermöglicht ein Einkoppeln des Vorbehandlungs-Magnetfelds rechtwinklig zur Substratoberfläche, wodurch sich beliebige Pinningrichtungen tangential zur Substratoberfläche im Sinne eines Multirichtungspinnens einstellen lassen. Durch ein derartiges Multirichtungspinnen ist es beispielsweise möglich, hochgenaue Winkelsensoren mit Oberwellenfilterung des Sensorsignals, wie sie beispielsweise in der WO 2016/083420 A1 beschrieben sind, herzustellen. Allerdings können im praktischen Einsatz mit diesem Verfahren nur geringe Pinningflussdichten in Bereichen weit unter 1 T erreicht werden, so dass dieses Verfahren bei Multischichtstapelstrukturen mit starken magnetischen Verkopplungen nicht einsetzbar ist.

Die US 2015/0213815 A1 offenbart einen magnetoresistiven Sensor, der einen zwischen einem oberen und einem unteren Schild angeordneten Schichtenstapel umfasst. Der Schichtenstapel besteht aus einer antiferromagnetischen Schicht, einer ersten ferromagnetischen Pinningschicht und einer zweiten ferromagnetischen Referenzschicht, wobei die beiden Schichten durch eine nichtmagnetische Kopplungsschicht miteinander antiparallel gekoppelt sind. Ein Quotient aus einem ersten magnetischen Moment der ersten ferromagnetischen Schicht und einem zweiten magnetischen Moment der zweiten ferromagnetischen Schicht beträgt über 1,1. Allerdings ist dort keine Anordnung oder ein Herstellverfahren von zwei benachbarten, identisch aufgebauten TMR-Elementen mit abweichenden Vorzugsrichtungen auf einem Substrat in einem magnetoresistiven Magnetfeldsensor bekannt

Aus der US 7,505,233 B2 geht einen Magnetfeldsensor bestehend aus zwei Sensoren hervor. Die beiden Sensoren umfassen jeweils zwei ferromagnetische Elemente und ein magnetoresistives Element mit einer Empfindlichkeit in einer X-Y Ebene. Mit dem magnetoresistiven Element ist ein in Z-Richtung geführtes externes, zu messendes Magnetfeld nicht messbar. Dadurch, dass das in Z-Richtung geführte Magnetfeld durch die beiden ferromagnetischen Elemente in X-Richtung abgelenkt werden kann, kann das zu messende Magnetfeld mittels des magnetoresistiven Elements gleichsinnig erfasst werden. Insoweit dienen die ferromagnetischen Elemente zur Ablenkung und Flussführung eines zu messenden z-Magnetfeldes in die X-Y Ebene. Der dort beschriebene magnetoresistive Magnetfeldsensor weist keine Schichtstruktur mit zwei ferromagnetischen Referenzschichten auf, außerdem sind keine zweite benachbarte und identisch aufgebaute TMR-Elementen mit abweichenden Vorzugsrichtungen auf einem Substrat gezeigt.

Die US 2017/0328963 A1 lehrt ein Verfahren zur permanenten Magnetisierung einer ferromagnetischen Schicht einer Magnetfeldsensorvorrichtung. Ein Pinningfeld wird senkrecht zu einer Chipsubstratoberfläche eingekoppelt, wobei durch eine Berandungsform eines weichmagnetischen Strukturierungselements horizontal ausgerichtete Magnetfeldkomponenten erzeugt werden, die in einstellbaren Richtungen in einer Chipsubstratebene ein Pinnen ermöglichen. Hierdurch wird ermöglicht, dass Magnetfeldsensorelemente gemeinsam und gleichzeitig auf einer Chipsubstratoberfläche in verschiedenen Achsrichtungen gepinnt werden, die in zwei oder mehreren beliebig abgewinkelten Richtungen hochsensitiv sind. Diese Druckschrift bezieht sich auf Sensorschichtstruktur mit nur einer einzigen, gepinnten Referenzschicht, sogenannte SSV-Schichtstapel, eine Anwendung von antiparallelen Referenzschichten oder Maßnahmen zum Pinnen mit verringerter Pinningfeldstärke ist nicht erläutert und es wird auch kein diesbezüglicher Aufbau nahegelegt.

Aus der US 2015/0318465 A1 betrifft eine magnetoresistive Vorrichtung umfassend eine magnetoresistive Struktur zum Messen eines Magnetfelds mit verschiedenen Breiten eines TMR-Schichtstapels. Die magnetoresistive Struktur ist in Art einer aufeinander geschichteten Doppel TMR Schicht mit zwei TMR Barrieren in einem Schichtstapel aufgebaut Ein Freelayer ist zwischen den beiden TMR-Schichtstapel angeordnet und oberhalb und unterhalb sind weiterhin Referenzschichten angeordnet. In ähnlicher Weise betrifft die US 7 605 437 B2 ebenfalls eine aufeinander geschichteten Doppel TMR Schicht mit zwei TMR Barrieren in einem Schichtstapel,

DE 11 2010 003 775 T5 beschreibt einen Feldsensor, der in einer X-Y-Ebene auch eine Z-Komponente erfassen kann. Hierzu umfasst der Sensor enthält weichmagnetische Flussführungen, deren einziger Zweck ist, das senkrechte Magnetfeld in die Ebene umzuleiten. Dabei haben alle magnetoresistiven Elemente identische Pinningrichtungen.

Die US 2018/0238972 A1 betrifft ähnlich wie die DE 11 2010 003 775 T5 einen Feldsensor zur Bestimmung einer Z-Komponente in einer X-Y-Ebene. Es ist erläutert, wie die z-Komponente durch Führung des zu messenden Feldes mittels weichmagnetischer Strukturen erfasst werden kann.

Ein weiterer relevanter Feldsensor, sowie Verfahren zu dessen Herstellung, sind in der folgenden Publikation offenbart: FREITAS PAULO P ET AL: "Spintronic Sensors", PROCEEDINGS OF THE IEEE, IEEE. NEW YORK, US, Bd. 104, Nr. 10, 1. Oktober 2016 (2016-10-01), Seiten 1894-1918, ISSN: 0018-9219, DOI: 10.1109/JPROC.2016.2578303.

Es ist die Aufgabe der vorliegenden Erfindung, eine Schichtstruktur für einen magnetoresistiven Magnetfeldsensor, einen magnetoresistiven Magnetfeldsensor sowie Verfahren zum Herstellen der Schichtstruktur bzw. des Magnetfeldsensors anzugeben, welche gegenüber dem Stand der Technik verbessert sind.

OFFENBARUNG DER ERFINDUNG

Die Lösung der Aufgabe erfolgt durch eine Anordnung von zumindest zwei benachbarten Schichtstrukturen, einen magnetoresistiven Magnetfeldsensor, der diese Anordnung nutzt, sowie durch ein Verfahren zum Herstellen dieser Anordnung von Schichtstrukturen und durch ein Verfahren zum Herstellen eines magnetoresistiven Magnetfeldsensors nach den unabhängigen und nebengeordneten Ansprüchen.

In der Anordnung von zumindest zwei benachbart angeordneten Schichtstrukturen umfasst jede Schichtstruktur zumindest eine antiferromagnetische Schicht, eine erste ferromagnetische Schicht mit einem ersten magnetischen Moment, wobei zwischen der antiferromagnetischen Schicht und der ersten ferromagnetischen Schicht eine Austauschkopplung besteht, und eine zweite ferromagnetische Schicht mit einem zweiten magnetischen Moment, wobei die zweite ferromagnetische Schicht über eine zwischen der ersten und der zweiten ferromagnetischen Schicht angeordneten nichtmagnetischen Kopplungsschicht mit der ersten ferromagnetischen Schicht antiparallel gekoppelt ist.

Es wird vorgeschlagen, dass die Magnetisierung, d.h. die Pinningrichtung der korrespondierten ersten und korrespondierten zweiten ferromagnetischen Schichten der benachbart angeordneten Schichtstrukturen voneinander abweichen, insbesondere im Wesentlichen entgegengesetzt zueinander ausgerichtet sind. Entgegengesetzt bedeutet eine antiparallele Ausrichtung, d.h. die beiden Pinningrichtungen sind zueinander um 180° gedreht. Eine im Wesentlichen entgegengesetzte Ausrichtung erlaubt auch eine Abweichung in einem Winkelbereich von 160° bis 200° voneinander, so dass die Pinningrichtungen im Wesentlichen um 180° antiparallel, d.h. entgegensetzt ausgerichtet sind, und von einer antiparallelen Ausrichtung eine weitere Abweichung von bis zu +/- 20° erlauben.

Benachbart bedeutet, dass die benachbarten Schichtstrukturen auf einem Substrat flächig nebeneinander angeordnet sind und zwischen den benachbarten Schichtstrukturen keine weiteren Schichtstrukturen angeordnet sind. Ist von mehreren benachbarten Schichtstrukturen die Rede, so bedeutet das, dass jede diese mehreren Schichtstrukturen mindestens eine weitere Schichtstruktur hat, zwischen denen keine weitere Schichtstruktur liegt. Es ist aber möglich, dass zwischen zwei benachbarten Schichtstrukturen andere Strukturen liegen, z.B. eine Leiterbahn oder ein Flussführungselement, bzw. ein weichmagnetisches Strukturierungselement. Es ist gleichfalls denkbar, dass zwischen zwei benachbarten Schichtstrukturen eine sogenannte blinde Schichtstruktur liegen kann, also eine Schichtstruktur, deren Widerstand nicht in den Widerstand des Sensors eingeht, die quasi nur als Platzhalter-Schichtstruktur vorhanden ist und deren Magnetisierungsrichtung keine Rolle spielt in dem Widerstandsverhalten des Sensors.

Die antiferromagnetische Schicht, die erste und zweite ferromagnetische Schicht und die Kopplungsschicht bilden einen Referenzschichtstapel, welcher sich durch die Verwendung der beiden ferromagnetischen Schichten bei sehr geringen Magnetfeldstärken pinnen lässt. Das resultierende magnetische Gesamtmoment $M\_APP\_SV$ der beiden ferromagnetischen Schichten $M_{FM1}$ und $M_{FM2}$ der Schichtstruktur ergibt sich aus:

$$M\_APP\_SV = M_{FM1} - M_{FM2} < M_{SSV,}$$

und ist wesentlich kleiner als das resultierende Moment Mssv einer Simple Spin Valve Schichtstruktur (SSV) mit vergleichbaren magnetoresistiven Eigenschaften. Diese Schichtstruktur kann als nicht balancierte antiparallel gekoppelte gepinnte Schichtstruktur (APP - antiparalelly coupled pinned layer spinvalve) bezeichnet werden.

Gegenüber der eingangs genannten Schichtstruktur, insbesondere gegenüber balancierten APP-Strukturen mit einem magnetischen Gesamtmoment von nahezu Null reduziert sich die benötigte Pinningfeldstärke größenordnungsmäßig um einen Faktor 10. Somit stellt die erfindungsgemäße Schichtstruktur eine Optimierung hinsichtlich der Durchführbarkeit des Pinning-Prozesses, der thermischen und magnetischen Stabilität und der Größe des xMR-Effekts dar. Aufgrund der hierdurch deutlich herabgesetzten Stärke des Pinningfelds können erstmals eng benachbarte Schichtstrukturen in unterschiedlichen Richtungen gepinnt werden.

Vorteilhafterweise weist jede Schichtstruktur eine runde oder elliptische Außenkontur auf. Weiterhin können die benachbarten Schichtstrukturen vorteilhafterweise identisch in Bezug auf die Layerabfolge, Layerschichtdicken und der verwendeten Layermaterialien aufgebaut sein. Dabei können die ersten ferromagnetischen Schichten der mindestens zwei benachbarten Schichtstrukturen identisch in Material und Schichtdicke, und die zweiten ferromagnetischen Schichten der mindestens zwei benachbarten Schichtstrukturen identisch in Material und Schichtdicke ausgebildet sein. Auch können die nichtmagnetischen Kopplungsschichten der mindestens zwei benachbarten Schichtstrukturen identisch in Material und Schichtdicke und die antiferromagnetischen Schichten der mindestens zwei benachbarten Schichtstrukturen identisch in Material und Schichtdicke ausgebildet sein.

Der Mittenabstand $\Delta D$ der benachbarten Schichtstrukturen beträgt 50 $\mu$m oder weniger. In einer vorteilhaften Ausführungsform kann der Mittenabstand bevorzugt 20 $\mu$m oder weniger, insbesondere 10 $\mu$m für kleine Schichtstrukturen oder weniger betragen. Somit können durch die enge Beabstandung auf engsten Raum bei gleichartigen Materialeigenschaften und Herstellprozessbedingungen unterschiedliche Pinningrichtungen von praktisch identisch aufgebauten Schichtstrukturen erreicht werden. Denn in dem engen Abstandsbereich zwischen den benachbarten Schichtstrukturen kann beispielsweise ein weichmagnetisches Strukturierungselement eingebracht werden. Wird dieses von einem Vorbehandlungsmagnetfeld, das vorzugsweise senkrecht zur Lage der Schichtstapelebenen ausgerichtet ist, durchsetzt, entsteht an der Berandung des Strukturierungselement ein magnetisches Streufeld, das senkrecht zur Berandungskante des Strukturierungselement die benachbarten Schichtstrukturen als Pinningfeld durchsetzt. Somit lassen sich je nach Form des Strukturierungselements (rechteckig, quadratisch, viereckig, polygon, abgerundet etc.) verschiedenste Pinningrichtungen in den lediglich durch einen Abstand kleiner 50 μm, bevorzugt kleiner als 20 μm, insbesondere kleiner als 10 μm beabstandeten benachbarten Schichtstrukturen erreichen. Dieser Abstand kann als Mindestabstand angesehen werden, wobei in realen Strukturen eine Reihe von beabstandeten Schichtstrukturen funktional zueinander angeordnet und elektrisch verschaltet sind, und wobei zumindest zwei benachbarte Schichtstrukturen, aber nicht zwingend alle Schichtstrukturen diesen Mindestabstand erreichen.

Die antiferromagnetische Schicht jeder Schichtstruktur kann beispielsweise aus FeMn, IrMn, PtMn, NiMn hergestellt sein, und eine Dicke zwischen 5 nm und 30 nm aufweisen.

Die Kopplungsschicht jeder Schichtstruktur, welche eine antiparallele Ausrichtung der zweiten ferromagnetischen Schicht bezüglich der ersten ferromagnetischen Schicht bewirkt, kann beispielsweise aus einem metallischen, nichtmagnetischen Material bestehen, beispielsweise aus Ru oder Rh, und eine Dicke zwischen 0,3 nm und 1,5 nm aufweisen.

Bevorzugte Ausgestaltungen der ersten und zweiten ferromagnetischen Schichten jeder Schichtstruktur werden nachfolgend noch näher beschrieben.

In einer vorteilhaften Ausgestaltung kann die Anordnung von Schichtstrukturen zumindest drei, insbesondere vier oder mehr Schichtstrukturen umfassen, die, insbesondere nur durch einen Zwischenraum, oder ein weichmagnetisches Strukturierungselement, voneinander getrennt, benachbart zueinander angeordnet sind. Insbesondere sind die Magnetisierungen der Schichtstrukturen paarweise abgewinkelt, bevorzugt um 90°, aber auch um 60°, 45°, 36°. 30°, 18° oder 15° abgewinkelt, zueinander angeordnet, und die Magnetisierung der korrespondierten ersten und korrespondierten zweiten ferromagnetischen Schichten jedes Paares der benachbarten Schichtstrukturen jedes Paares weichen voneinander ab, bevorzugt im Wesentlichen entgegengesetzt, d.h. antiparallel voneinander ab. Insbesondere sind die Pinningrichtungen der Magnetisierung eines Paares von gegenüberliegender Schichtstrukturen um im Wesentlichen 180° entgegengesetzt zueinander ausgerichtet. Somit können nicht nur zwei voneinander abweichende, insbesondere um im Wesentlichen 180° entgegengesetzt ausgerichtete Pinningrichtungen benachbarter Schichtstrukturen erreicht werden. Sondern es können z.B. zweimal zwei oder mehrere Paare von Schichtstrukturen, beispielsweise sechsmal zwei Paare mit voneinander abweichende Pinningrichtungen bereitgestellt werden, wobei jeweilig zueinander korrespondierende Paare aus, insbesondere mit um im Wesentlichen 180° entgegengesetzt ausgerichteten Pinningrichtungen ausgestatteten Schichtstrukturen wiederum um einen beliebigen Winkel, z.B. 90°, aber auch z.B. 15°, 18°, 30°, 36°, 45° oder 60° zueinander versetzt sein können. Somit lässt sich z.B. eine Anordnung von Schichtstrukturen zur Oberwellenfilterung für eine Fehlerminimierung von Drehwinkelsensoren realisieren, wie sie beispielsweise in der WO 2016/083420 A1 beschrieben ist. Auch können die jeweils paarweise korrespondierenden und gegenüberliegenden Schichtstrukturen eine von 180° abweichende Pinningrichtung, aber auch z.B. 160° oder 200° abweichende Pinningrichtung aufweisen. Dies kann durch eine keilförmige Außenstruktur eines weichmagnetischen Strukturierungselements erreicht werden und kann zur Filterung hochfrequenter Oberwellenfehler genutzt werden. So können eine Seitenfläche des Strukturierungselements beispielsweise einen gestuften Winkelverlauf, bevorzugt einen der Winkel 15°, 18°, 30°, 36°, 45°, 60°,75° oder 90° einschließenden Winkelverlauf aufweisen, wobei gegenüberliegende Seitenflächen bevorzugt an einer Mittenachse gespiegelt ausgebildet sein können. Auch können beispielsweise mehr als vier, z.B. sechs, acht oder mehrere Paare von Schichtstrukturen bevorzugt spiegelsymmetrisch oder rotationssymmetrisch zueinander angeordnet sein. Bei sechs Paaren bietet es sich an, diese um jeweils 30° zueinander versetzt sind, oder vier Paare, die um 45° zueinander versetzt sind, wobei die jeweiligen Paare eine um 180° gegenüberliegende Magnetisierung, d.h. Pinningrichtung aufweist.

Ausgehend von der oberen Ausführungsform sind somit bevorzugt zwei Paare von Schichtstrukturen benachbart zueinander angeordnet, wobei ein erstes Paar von Schichtstrukturen im Wesentlichen entgegengesetzt magnetisiert ist und ein zweites Paar von Schichtstrukturen paarweise im Wesentlichen entgegengesetzt magnetisiert ist. Dabei kann weiterhin die Magnetisierungsrichtungen des zweiten Paares nicht identisch mit den Magnetisierungsrichtungen des ersten Paares sein, und vorzugsweise um 90°, 60°, 45°, 36°, 30°, 18° oder 15° abgewinkelt sind. Somit sind die Pinningrichtungen der Schichtstrukturen jeweils paarweise antiparallel und die Pinningrichtungen benachbarter Paare von Schichtstrukturen weisen in einem Winkel von 90° oder weniger voneinander ab. Auch können die Einzellayer der Schichtstrukturen der Paare von Schichtstrukturen jeweils zueinander identisch bezüglich Material und Schichtdicke ausgebildet sein.

In einer vorteilhaften Ausführungsform kann in jeder Schichtstruktur der Quotient aus dem ersten magnetischen Moment der mit der antiferromagnetischen Schicht gekoppelten ersten ferromagnetischen Schicht und dem zweiten magnetischen Moment der zweiten ferromagnetischen Schicht, die antiparallel mit der ersten ferromagnetischen Schicht gekoppelt ist, ungleich 1 sein, und bevorzugt zwischen 1,7 und 2,3 betragen. Somit weist die mit der antiferromagnetischen Schicht per Austauschkopplung gekoppelte erste ferromagnetische Schicht ein ungefähr doppelt so hohes magnetisches Moment auf wie die zweite ferromagnetische Schicht, welche sich auf der der antiferromagnetischen Schicht abgewandten Seite der ersten ferromagnetischen Schicht befindet, und die mit der ersten ferromagnetischen Schicht über eine nichtmagnetischen Kopplungsschicht antiparallel gekoppelt ist.

Der genannte Quotient der ersten und zweiten magnetischen Momente bezieht sich beispielsweise auf den Zustand der abgeschiedenen, jedoch noch nicht gepinnten ersten und zweiten ferromagnetischen Schichten oder kann sich auch auf den Zustand nach dem Pinnen der beiden Schichten beziehen.

Gemäß einer vorteilhaften Ausführungsform umfasst jede Schichtstruktur eine dritte ferromagnetische Schicht, welche an der der Kopplungsschicht abgewandten Seite der zweiten ferromagnetischen Schicht angeordnet ist, wobei insbesondere zwischen der zweiten und dritten ferromagnetischen Schicht eine nichtmagnetische, insbesondere nichtleitende Barriereschicht, bevorzugt aus MgO, angeordnet ist. Die dritte ferromagnetische Schicht ist üblicherweise als Detektionsschicht ausgestaltet. Die dritte ferromagnetische Schicht ist bevorzugt aus Co, CoFe, NiFe oder CoNi hergestellt, wobei gegebenenfalls ein oder mehrere weitere Elemente mit einlegiert sein können, insbesondere Bor oder Silizium. Sie kann auch als Mehrschichtsystem verschiedener Materialien bestehen, die weichmagnetisches CoFe oder NiFe enthalten. Die Barriereschicht dient insbesondere dazu, den magnetoresistiven Tunneleffekt zu optimieren.

Weiterhin kann gemäß der vorstehenden Ausführungsform jede Schichtstruktur zumindest eine nichtmagnetische, insbesondere metallische Deckschicht umfassen, welche an der, der zweiten ferromagnetischen Schicht abgewandten, Seite der dritten ferromagnetischen Schicht angeordnet ist. Die Deckschicht grenzt die Schichtstruktur gegenüber darüber liegenden benachbarten Strukturen ab und kann insbesondere auch zur Durchleitung der Messströme dienen.

Im Anschluss an eine Deckschicht jeder Schichtstruktur oder ggf. direkt auf der dritten ferromagnetischen Schicht kann eine abschließende Abschlusselektrodenschicht aufgesetzt werden, die als Kontaktelektrode für die elektrische Kontaktierung dienen kann.

Die Abschluss- bzw. Deckschichten sind bevorzugt auf allen Schichtstrukturen bzgl. Material und Schichtdicken identisch.

Jede Schichtstruktur ist vorteilhafterweise auf einem Substrat aufgebracht, wobei zwischen dem Substrat und der antiferromagnetischen Schicht eine sogenannte Saatschicht aufgebracht werden kann, welche das Aufwachsen der antiferromagnetischen Schicht fördern kann, und die als Basiselektrode dienen kann. Grundsätzlich kann die Schichtstruktur zwischen der Saat und der Deck- bzw. Abschlusselektrodenschicht in umgekehrter Reihenfolge als hier beschrieben auf einem Substrat aufgebracht werden.

Gemäß einer weiteren vorteilhaften Ausführungsform der Erfindung besteht in jeder Schichtstruktur die erste ferromagnetische Schicht aus einer ersten ferromagnetischen Materialzusammensetzung und die zweite ferromagnetische Schicht aus einer zweiten ferromagnetischen Materialzusammensetzung, wobei die erste ferromagnetische Materialzusammensetzung von der zweiten ferromagnetischen Materialzusammensetzung verschieden ist. Durch die unterschiedlichen Materialzusammensetzungen, welche sich hinsichtlich der enthaltenen chemischen Elemente und/oder deren Anteile unterscheiden können, wird die Ausbildung der unterschiedlichen magnetischen Momente der ferromagnetischen Schichten des Referenzschichtstapels gefördert.

Vorteilhafterweise ist die erste ferromagnetische Materialzusammensetzung eine CoFe-Legierung, wobei insbesondere der Stoffmengenanteil, bzw. der Atomprozentanteil an Fe zwischen 5% und 15%, bevorzugt 10% beträgt.

Vorteilhafterweise ist in jeder Schichtstruktur die zweite ferromagnetische Materialzusammensetzung eine CoFeB-Legierung, wobei im Rahmen einer jeweiligen Toleranzabweichung der Stoffmengenanteil, bzw. der Atomprozentanteil an Co und Fe jeweils 40% und der Anteil an B 20% beträgt, wobei die Toleranzabweichung umfasst, dass ein jeweiliger Anteil um nicht mehr als 5 Prozentpunkte, bevorzugt um nicht mehr als 2,5 Prozentpunkte von dem jeweiligen genannten Wert für den Anteil abweicht.

Die vorstehend genannten Materialzusammensetzungen haben sich als besonders geeignet erwiesen, um die ferromagnetischen Schichten mit dem gewünschten Verhältnis ihrer magnetischen Momente auszubilden.

Gemäß einer vorteilhaften Ausführungsform weist in jeder Schichtstruktur die erste ferromagnetische Schicht eine erste Schichtdicke $\Delta l1$ und die zweite ferromagnetische Schicht $\Delta l2$ eine zweite Schichtdicke auf, wobei der Quotient $\Delta l1/\Delta l2$ aus der ersten und der zweiten Schichtdicke zwischen 1,2 und 2,5 beträgt.

Vorteilhafterweise beträgt in jeder Schichtstruktur die erste Schichtdicke $\Delta l1$ zwischen 0,5 nm und 2,0 nm, bevorzugt 1,2 nm, und die zweite Schichtdicke $\Delta l2$ ist derart gewählt, dass der Quotient aus dem ersten und dem zweiten magnetischen Moment zwischen 1,7 und 2,3 beträgt, wobei insbesondere der Quotient der magnetischen Momente auf den Zustand der abgeschiedenen, jedoch noch nicht gepinnten ersten und zweiten ferromagnetischen Schichten bezogen ist.

Für die beiden vorstehend genannten bevorzugten Materialzusammensetzungen, d. h. Co90Fe10 für die erste ferromagnetische Schicht und Co40Fe40B20 für die zweite ferromagnetische Schicht, beträgt der Quotient aus der ersten und der zweiten Schichtdicke vorzugsweise zwischen 1,36 und 1,84, insbesondere 1,6.

Gemäß einer vorteilhaften Ausführungsform umfasst die Kopplungsschicht jeder Schichtstruktur, insbesondere ausschließlich, Ru und weist eine Dicke zwischen 0,35 nm und 0,85 nm, bevorzugt 0,5 nm auf. Eine derartige Bemessung der Kopplungsschicht hat sich als besonders geeignet erwiesen.

Vorteilhafterweise kann die antiferromagnetische Schicht jeder Schichtstruktur als eine Manganlegierung ausgebildet sein. Insbesondere bietet sich hierfür eine Legierung aus Iridium-Mangan (IrMn), Platin-Mangan (PtMn), Nickel-Mangan (NiMn), Eisenmangan (FeMn) oder eine Legierungsgemisch hiervon an. Bevorzugt liegt die Manganlegierung, insbesondere Platin-Mangan (PtMn), Nickel-Mangan (NiMn) in einer in der geordneten $L1_0$-Phase vor. Eine $L1_0$-Phase ist eine intermetallische Ordnungsphase der Metalllegierung, die sich durch eine regelmäßige Struktur der Mischkristalle auszeichnet, durch die die antiferromagnetischen Eigenschaften der Manganlegierung sehr ausgeprägt erscheinen. Derartige antiferromagnetische Schichten auf Manganbasis behalten bzw. erreichen ihre ausgezeichneten antiferromagnetischen Eigenschaften selbst bei mehrstündigen Pinningzeiten und Temperaturen oberhalb der Blockingtemperatur. Für gesputterte PtMn und NiMn Schichten ist bekannt, dass erst bei mehrstündigem Heizen bei Temperaturen oberhalb 225°C sich die bevorzugte L1o Kristallordnung eingestellt hat, wobei eine derartige Kristallordnung optimale antiferromagnetische Eigenschaften erreicht, und dies durch kurzfristiges Erhitzen wie bei einem selektiven Laserpinningverfahren nicht erreichbar ist.

Vorteilhafterweise ist jede Schichtstruktur als ein TMR-System ausgebildet. Hierzu kann die Schichtstruktur eine untere Basiselektrode und eine obere Abschlusselektrode aufweisen, so dass die Schichtstruktur elektrisch kontaktierbar und senkrecht zum Schichtaufbau von Strom, d.h. senkrecht zur Substratoberfläche durchflossen werden kann. Bevorzugt ist die Saatschicht, die als Basisschicht auf dem Substrat zum Aufbau der Schichtstruktur, insbesondere der antiferromagnetischen Schicht genutzt wird, als elektrisch leitende Basiselektrode ausgebildet. Weiterhin kann in der ersten ferromagnetischen Schicht eine Magnetisierung in einer Pinningrichtung eingeprägt sein, und sich in der zweiten ferromagnetischen Schicht eine hierzu antiparallel ausgerichtete Magnetisierung einstellen, so dass eine sehr hohe Empfindlichkeit der Widerstandsänderung auf ein externes Magnetfeld in Pinningrichtung erreicht werden kann. Somit hat sich die erfindungsgemäße Schichtstruktur einschließlich ihrer vorteilhaften Ausführungsformen als besonders geeignet für die Anwendung in TMR-basierten Magnetfeldsensoren erwiesen, insbesondere in der Verwendung in Winkelsensoren und 2D-Feldsensoren. Eine Verwendung bei GMR-basierten Magnetfeldsensoren ist jedoch alternativ ebenfalls möglich, wobei hierzu die Basis- und Abschlusselektrode seitlich an der Schichtstruktur angeordnet sein können.

Vorteilhafterweise können zumindest zwei, identisch aufgebaute und benachbarten TMR-Elemente auf einem Substrat angeordnet sein und die Magnetisierungsrichtungen der korrespondierten ersten und korrespondierten zweiten ferromagnetischen Schichten können voneinander abweichen, insbesondere entgegengesetzt oder geringfügig um 180° verschieden aber im Wesentlichen antiparallel zueinander ausgerichtet sein. Die benachbarten TMR-Elemente umfassen dabei identische Schichtpakete und sind im identischen Abscheideprozess, insbesondere simultan hergestellt. Dabei kann bevorzugt der Mittenabstand $\Delta D$ der benachbarten TMR-Elemente 50 $\mu m$ oder weniger, bevorzugt 20 $\mu m$ oder weniger, insbesondere 10 $\mu m$ oder weniger betragen. Hierbei kann in eine zumindest temporäre Anordnung eines weichmagnetischen Strukturierungselements zwischen den beiden TMR-Elementen ein Vorbehandlungsmagnetfeld vorzugsweise senkrecht zur Substratoberfläche in das Strukturierungselement eingekoppelt werden. Entlang der Kanten des Strukturierungselement wirken Streufelder des Strukturierungselements, die Feldkomponenten enthalten, die parallel zur Substratoberfläche und senkrecht zum Seitenflächenverlauf des Strukturierungselements ausgerichtet sind, als wirksames Pinningfeld, um die magnetische Ausrichtung der ersten ferromagnetischen Schicht auszurichten. Hierzu kann ein relativ geringer Mittenabstand $\Delta D$ der Schichtstrukturen oder der TMR Elemente auf dem Substrat gewählt werden, und dazwischen das Strukturierungselement entweder auf dem Substrat aufgebaut, oder temporär eingebracht, beispielsweise in Form eines Stempels eingebracht werden. Das Vorbehandlungsmagnetfeld kann über dem Substrat vollflächig einwirken, wobei an den Positionen der Strukturierungselemente entsprechend deren Kantenausrichtungen ein Pinning in unterschiedliche Richtungen parallel zur Substratoberfläche durch die vom Vorbehandlungsmagnetfeld abgeleiteten lokal wirkenden Pinningfelder erreicht werden kann. Im Gegensatz zu herkömmlichen Laserpinningverfahren, bei denen ein In-Plane Pinningfeld, dass parallel zur Oberfläche des Substrats eingekoppelt wird - wobei somit das Vorbehandlungsmagnetfeld gleich dem Pinningfeld ist - und die Blocking-Temperatur durch kurzfristiges Lasererhitzen überschritten wird, ist gemäß dieser Weiterentwicklung ein ganzheitliches Pinnen in unterschiedliche Richtungen praktisch aller Schichtstrukturen auf einem Substrat über einen beliebig langen Zeitraum bei niedrigen Magnetfeldstärken möglich. In der Praxis bedeutet das, dass alle TMR Elemente aller Sensoren auf einem Wafersubstrat in einem Schritt gepinnt werden können.

Die vorgenannte Anordnung zweier oder mehrerer benachbarter, identisch aufgebauter und identisch abgeschiedener TMR-Elemente mit zueinander abgewinkelten, insbesondere zueinander antiparallelen Pinningrichtungen kann denkbar auch ohne die Limitierung eines Quotienten aus dem ersten und dem zweiten magnetischen Moment zwischen 1,7 und 2,3 ausgeführt sein. Entscheidend ist, dass die magnetischen Momente der beiden ferromagnetischen Schichten dergestalt ist, dass ein Pinning mit relativ geringen Magnetfeldstärken möglich ist, so dass ein vorstehend beschriebenes multidirektionales Pinningverfahren mit Strukturierungselementen auch mit TMR-Elementen ermöglicht wird.

Ein erfindungsgemäßer magnetoresistiver Magnetfeldsensor umfasst ein Substrat, eine Anordnung von zumindest zwei oder mehrere, auf dem Substrat benachbart angeordnete Schichtstrukturen nach einem der vorhergehenden Ausgestaltungen, und zumindest ein zumindest temporär einbringbares und benachbart oder teilweise überlappend zu einer jeweiligen Schichtstruktur angeordnetes weichmagnetisches Strukturierungselement, wobei das Strukturierungselement dazu ausgebildet und angeordnet ist, ein Vorbehandlungsmagnetfeld, welches in das Strukturierungselement eindringt, derart zu beeinflussen, dass zumindest in der ersten ferromagnetischen Schicht benachbarter Schichtstrukturen abweichend ausgerichtete Magnetfeldkomponenten als Streumagnetfeld des Strukturierungselements zur Nutzung als Pinningfeld wirksam werden, welche parallel zu einer Oberfläche der Schichtstruktur verlaufen. Bevorzugt ist das Vorbehandlungsmagnetfeld senkrecht zur Oberfläche des Substrats in das Strukturierungselement einkoppelbar. In der Regel wird nach dem Pinningvorgang das temporär eingebrachte Strukturierungselement wieder entfernt. In der Regel umfasst der Magnetfeldsensor eine oder mehrere Wheatstone-Messbrücken von magnetoresistiven Brückenwiderständen. Jeder Brückenwiderstand umfasst zumindest eine, insbesondere eine Vielzahl von in Reihe geschalteten Schichtstrukturen, die in der Regel eine im Wesentlichen gleichgerichtete Magnetisierungsrichtung aufweisen. Insofern können die jeweils zumindest paarweise benachbarten Schichtstrukturen der Anordnung jeweils in verschiedenen Brückenwiderständen der Wheatstone-Messbrücke verschaltet sein.

Das weichmagnetische Strukturierungselement, welches beispielsweise aus einer lithografisch strukturierten Nickel-Eisen-Legierung hergestellt ist, wird so angeordnet, dass ein Vorbehandlungsmagnetfeld in das oder die Strukturierungselemente gleichzeitig und senkrecht zur Oberfläche der jeweiligen Schichtstruktur eingekoppelt wird und am Ort der Schichtstruktur auch Magnetfeldkomponenten parallel zur Oberfläche der jeweiligen Schichtstruktur erzeugt, die zumindest bereichsweise die erste und zweite ferromagnetische Schicht durchdringen. Benachbarte Schichtstrukturen können so durch unterschiedlich ausgerichtete, bevorzugt im Wesentlichen entgegengesetzte Pinningfelder durchdrungen werden. So kann das Vorbehandlungsmagnetfeld ein homogenes Magnetfeld sein, das senkrecht auf die Oberfläche der Schichtstruktur auftrifft, und das durch die Magnetfeldführungseigenschaft und die geometrische Gestaltung des Strukturierungselements in Form eines inhomogenen Streufeldes auch parallel zur Schichtstrukturoberfläche an Berandungskanten austritt und ein Pinning der benachbarten Schichtstrukturen vornimmt. Hierdurch können beliebige Pinning-Richtungen in einer jeweiligen Schichtstruktur vorgesehen sein, wobei ein einzelnes Strukturierungselement auch mehrere Schichtstrukturen gleichzeitig und auch in verschiedene Richtungen pinnen kann. Die unterschiedlichen Pinningrichtungen hängen im Wesentlichen von der Umrissform des Strukturierungselements ab, die das Strukturierungselement gegenüber der Oberfläche des Substrats berandet.

Die Anordnung von weichmagnetischen Strukturierungselementen auf einem magnetoresistiven Magnetfeldsensor sowie entsprechende Verfahren zur Herstellung des Magnetfeldsensors, welche ein Pinnen der Schichtstrukturen des Magnetfeldsensors beschreiben, sind beispielhaft in WO 2016/078793 A1 beschrieben.

Aus diesem Dokument sind auch verschiedene Ausgestaltungen von weichmagnetischen Strukturierungselementen bekannt. Es hat sich überraschenderweise gezeigt, dass sich weichmagnetische Strukturierungselemente, wie sie in WO 2016/078793 A1 beschrieben sind, in besonderer Weise dafür eignen, Schichtstrukturen auf einem Magnetfeldsensor zu pinnen, was darauf zurückzuführen ist, dass zum Pinnen der erfindungsgemäßen Schichtstruktur nur ein Vorbehandlungsmagnetfeld mit verhältnismäßig niedriger Stärke, kleiner 130 mT ausreichend ist, und die hierbei entstehenden Pinningfelder, die in der Regel weniger als 80%, meist weniger als 50% der Stärke des Vorbehandlungsmagnetfelds aufweisen, nochmals deutlich geringer sind. Es ist insbesondere möglich, auf einem Magnetfeldsensor mehrere erfindungsgemäße Schichtstrukturen vorzusehen, welche in unterschiedliche Raumrichtungen magnetisiert sind und insbesondere eine Wheatstone-Brücke bilden, wie sie beispielsweise in der WO 2016/083420 A1 beschrieben ist.

Ein erfindungsgemäßes Verfahren zum Herstellen einer Anordnung von Schichtstrukturen nach einem der vorhergehenden Aspekte umfasst die Schritte:

- Aufbringen der Schichten auf ein Substrat in der genannten oder der umgekehrten Reihenfolge zwischen Deck- und Saatschicht, Erwärmen der Schichtstruktur auf eine Temperatur oberhalb einer Blocking-Temperatur, bei welcher die Austauschkopplung zwischen der antiferromagnetischen Schicht und der ersten ferromagnetischen Schicht aufgehoben ist,

- Einkoppeln eines , insbesondere senkrecht zur Oberfläche des Substrats (110) ausgerichteten, Vorbehandlungsmagnetfelds in die erwärmte Schichtstruktur zum Einstellen eines Pinningfelds mit abweichenden Magnetisierungsrichtungen der ersten ferromagnetischen Schicht benachbarter Schichtstrukturen zumindest während einer Zeitdauer, bei welcher die Temperatur der Schichtstruktur größer als die Blocking-Temperatur ist, und

- Abkühlen der Schichtstruktur auf eine Temperatur unterhalb der Blocking-Temperatur.

In einem ersten Schritt wird auf einem Chipsubstrat eine Anordnung von mindestens zwei, insbesondere eine Vielzahl von magnetoresistiven Schichtstrukturen benachbart zueinander aufgebracht, vorzugsweise GMR- oder TMR-Schichtstrukturen, die einen Schichtaufbau entsprechend einem oder mehrerer der vorstehend genannten Aspekte aufweisen. Insbesondere werden die Layer alle Schichtstrukturen im gleichen Beschichtungsprozess simultan abgeschieden werden, wodurch identische Schichtdicken und Materialen von benachbarten Schichtstrukturen erreicht werden. Auch können alle Strukturierungsprozesses vorzugsweise parallel und simultan an allen Schichtstrukturen erfolgen und nicht sequentiell erfolgen, sodass nicht erst eine erste Schichtstruktur geformt wird und danach eine zweite Schichtstruktur geformt wird. Es hat sich als äußerst vorteilhaft herausgestellt, dass alle Schichtstrukturen in einem identischen Beschichtungsprozess hergestellt werden, und keine sequentiellen oder ungleichartigen Behandlungen verschiedener Schichtstrukturen auf dem Substrat erfolgen. Zum Ausrichten der ersten ferromagnetischen Schicht oder Schichten wird eine Temperatur höher als die Blocking-Temperatur angelegt, sodass die Austauschwechselwirkung zwischen der ersten ferromagnetischen Schicht und der antiferromagnetischen Schicht aufgehoben wird. Die ferromagnetische Schicht ist nun nicht mehr durch die benachbarte antiferromagnetische Schicht gepinnt und verhält sich ähnlich wie eine freie Schicht. Anschließend erfolgt ein Einkoppeln eines externen Magnetfeldes, das auch als Vorbehandlungsmagnetfeld bezeichnet wird, wobei die Feldlinien des Magnetfeldes so geführt werden, dass diese an geeigneter Stelle in die Schichtstruktur als Pinningfeld parallel zur Schichtebene eintreten und dort eine einstellbare Magnetisierung der ersten ferromagnetischen Schicht bewirken.

Vorteilhafterweise wird die Anordnung der Schichtstrukturen auf mindestens 260°C, bevorzugt auf 280°C, erwärmt, was insbesondere bei Iridiummangan ausreicht, um die Blocking-Temperatur zu erreichen, und somit ein Pinning, d.h. eine Ausrichtung der Magnetisierung der ersten ferromagnetischen Schicht ermöglicht wird. Im Falle einer antiferromagnetischen Schicht umfassend eine PtMn- oder NiMn-Legierung liegen die typischen Temperaturen bei vorzugsweise über 300°C, insbesondere zwischen 300°C und 350°C.

Vorteilhafterweise beträgt die magnetische Flussdichte des eingekoppelten Vorbehandlungsmagnetfelds nicht mehr als 200 mT, bevorzugt nicht mehr als 100 mT, so dass TMR-Elemente oder GMR-Elemente auf Basis von antiparallel gekoppelten Spin Valve Schichtstrukturen (APP - antiparalelly coupled pinned layer spinvalve) leicht und kostengünstig herstellbar sind.

Vorteilhafterweise beträgt eine Zeitdauer, für welche das Pinningfeld in die oberhalb der Blocking-Temperatur erwärmte Anordnung der Schichtstrukturen eingekoppelt wird, mindestens 1 h, bevorzugt mindestens 5 h, besonders bevorzugt mindestens 12 h. Durch die sehr lange Einkoppelzeit bei hohen Temperaturen kann eine geordnete L1o Schichtausrichtung der antiferromagnetischen Schicht erreicht und somit die antiferromagnetischen Eigenschaften wesentlich verbessert werden.

Ein erfindungsgemäßes Verfahren zum Herstellen eines erfindungsgemäßen magnetoresistiven Magnetfeldsensors, welcher gemäß dem vorstehend beschriebenen Aspekt zumindest ein weichmagnetisches Strukturierungselement umfasst, umfasst das vorstehend beschriebene erfindungsgemäße Verfahren zum Herstellen einer Anordnung von Schichtstrukturen einschließlich der vorteilhaften Ausgestaltungen des Verfahrens, und ein zumindest temporäres Aufbringen des zumindest einen Strukturierungselements.

Erfindungsgemäß wird das Vorbehandlungsmagnetfeld über das Strukturierungselement als Pinningfeld in benachbarte Schichtstrukturen mit abweichenden Magnetisierungsrichtungen eingekoppelt. Bevorzugt kann das Strukturierungselement nach Abschluss des Pinnings wieder entfernt werden, so dass es beispielsweise mit üblichen lithographischen und galvanischen Verfahren auf dem Substrat temporär aufgebracht und mittels Ätzverfahren bzw. materialabtragenden Verfahren wieder entfernt werden kann. Auch ist denkbar, die Strukturierungselemente in Form eines Stempels temporär über das Substrat abzusenken, und das Vorbehandlungsmagnetfeld derart einzukoppeln. Alternativ können die weichmagnetischen Strukturierungselemente auch als Flussführungselemente für das externe Magnetfeld zumindest bereichsweise erhalten bleiben.

In einer vorteilhaften Weiterbildung des voranstehenden Herstellverfahrens kann eine Anordnung von zumindest zwei benachbarte und zueinander beabstandete Schichtstrukturen auf dem Substrat aufgebracht werden, und das Strukturierungselement zwischen den Schichtstrukturen zumindest temporär aufgebracht werden. Während des Erwärmens über die Blocking-Temperatur kann ein Vorbehandlungsmagnetfeld senkrecht zur Oberfläche des Substrats in das bzw. die Vielzahl von Strukturierungselementen eingekoppelt werden, so dass ein von den Strukturierungselementen erzeugtes inhomogenes Streumagnetfeld im Wesentlichen parallel zur Oberfläche des Substrats die gewünschten Ausrichtungen des Pinningfelds bereitstellt. Die Ausrichtung der pinningwirksamen Magnetfeldanteile parallel zur Substratoberfläche aus dem Vorbehandlungsmagnetfeld hängt von der Kantengeometrie des Strukturierungselements ab, so dass bevorzugt die Ausrichtung des Pinningfelds der benachbarten Schichtstrukturen voneinander abweichen, insbesondere im Wesentlichen entgegengesetzt ausgerichtet sind. Durch diese Weiterbildung des Herstellverfahrens können mit einem relativ schwachen Vorbehandlungsmagnetfeld, geringer als 200mT bevorzugt geringer als 100 mT, GMR- und TMR-Elemente in räumlich eng benachbarter Anordnung in unterschiedliche Vorzugsrichtungen gepinnt werden, obwohl die Referenzschichten der GMR- bzw. TMR Elemente zwei antiparallel gekoppelte Ferromagnete enthalten.

Durch die Kombination der Verfahren, insbesondere der Möglichkeit des zeitlich langen Pinnens über mehrere Minuten bis Stunden, und der speziellen Abfolge der Schichtstrukturen bei eng benachbarten Anordnungen und Materialien (Materialwahl) ist es also möglich, thermisch besonders robuste antiferromagnetische Materialien wie PtMn und NiMn in einer optimierten L1o Phase mit zusätzlich thermisch robusten antiferromagnetischen gekoppelten ersten und zweiten ferromagnetischen Schichten in Sensoren einzusetzen und zusätzlich verschiedene TMR- oder GMR- Elemente auf engem Raum zu platzieren, die identisch ausgeprägt und hergestellt sind bis auf die Pinningrichtungen der Referenzschicht, welche teilweise in der Richtung abweichen bevorzugt im Wesentlichen entgegengesetzt, d.h. in einem Winkelbereich von 160° bis 200° zueinander, ausgerichtet sind.

Weitere vorteilhafte Ausgestaltungen der Schichtstruktur, des magnetoresistiven Magnetfeldsensors und der Herstellungsverfahren ergeben sich aus der Beschreibung, den Figuren und den Unteransprüchen.

ZEICHNUNGEN

Weitere Vorteile ergeben sich aus den vorliegenden Zeichnungen und den zugehörigen Zeichnungsbeschreibungen. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

**Fig. 1** eine schematische Schnittdarstellung einer Schichtstruktur für eine Anordnung gemäß einem Ausführungsbeispiel der Erfindung,

**Fig. 2a,b** schematisch eine Schnittdarstellung einer Schichtstruktur für eine erfindungsgemäße Ausführungsform einer Anordnung dieser Schichtstrukturen umfassendes TMR-,

**Fig. 3** schematisch eine Schnittdarstellung einer Ausführungsform einer Anordnung eines Paares von Schichtstrukturen als TMR-Elemente gemäß eines Ausführungsbeispiels der Erfindung,

**Fig. 4** eine perspektivische Ansicht eines magnetoresistiven Magnetfeldsensors mit einer Anordnung mehrerer Schichtstrukturen und einem weichmagnetischen Strukturierungselement gemäß einem Ausführungsbeispiel,

**Fig. 5** schematisch ein Pinningschritt des in Fig. 4 dargestellten Magnetfeldsensors, und

**Fig. 6** eine Draufsicht auf einen magnetoresistiven Magnetfeldsensor während eines Pinningprozesses gemäß einem Ausführungsbeispiel;

**Fig. 7** schematische Darstellungen von Ausführungsformen einer Anordnung von Schichtstrukturen mit abweichenden Pinningrichtungen.

In den Figuren sind gleichartige Elemente mit gleichen Bezugszeichen beziffert.

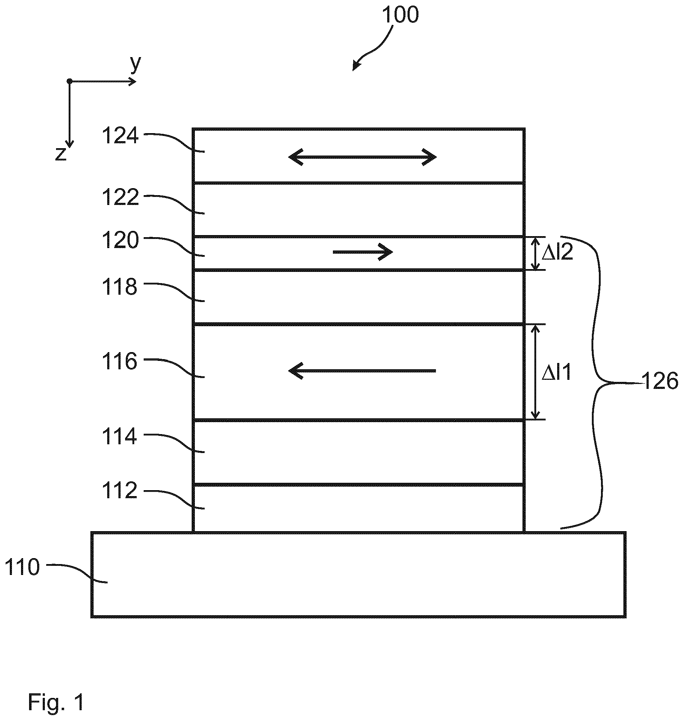

Fig. 1 zeigt eine Ausführungsform einer Schichtstruktur 100 für eine erfindungsgemäße Anordnung, welche im vorliegenden Ausführungsbeispiel als TMR-System beschrieben ist. Für eine Ausgestaltung als GMR-System gemäß einer Abwandlung des Ausführungsbeispiels sind dem Fachmann die Änderungen, die er in Abweichung von einem TMR-System vornehmen muss, allgemein bekannt.

Die verschiedenen Schichten der Schichtstruktur 100 werden durch Beschichtungsverfahren aufgebracht, welche in der Halbleitertechnologie allgemein bekannt und gebräuchlich sind, beispielsweise Verfahren zur chemischen oder physikalischen Gasphasenabscheidung.

Mehrere Schichtstrukturen 100 sind auf einem Halbleitersubstrat oder Substrat 110 aufgebracht. Zunächst wird auf dem Substrat 110 eine Saatschicht 112 aufgebracht, welche so gewählt ist, dass eine nachfolgend aufgebrachte antiferromagnetische Schicht 114 mit optimalen Eigenschaften aufwächst. Die Saatschicht 112 zeichnet sich durch eine hinreichend große elektrische Leitfähigkeit und eine möglichst geringe Oberflächenrauigkeit aus, so dass diese als Basiselektrode 132 einen ersten elektrischen Anschlusspunkt bildet.

Auf die Saatschicht 112 wird die antiferromagnetische Schicht 114 aufgetragen, welche auch als Pinningschicht bezeichnet werden kann. Die antiferromagnetische Schicht 114 besteht beispielsweise aus FeMn, NiMn, IrMn oder PtMn mit einer typischen Schichtdicke zwischen 5 nm und 30 nm.

Auf die antiferromagnetische Schicht 114 wird nachfolgend eine erste ferromagnetische Schicht 116 aufgetragen, welche aus einer CoFe-Legierung, typischerweise Co90Fe10 (Angaben in Massen-Prozentanteilen) mit einer Dicke von 0,5 nm bis 2,0 nm, typischerweise 1,2 nm aufgetragen wird.

An die erste ferromagnetische Schicht 116 schließt sich eine Zwischenschicht oder Kopplungsschicht 118 an, welche beispielsweise aus Ru mit einer Dicke zwischen 0,35 nm und 0,85 nm, typisch 0,5 nm, hergestellt ist. Die Kopplungsschicht 118 bewirkt über die RKKY-Kopplung eine antiparallele magnetische Ausrichtung einer zweiten ferromagnetischen Schicht 120 in Bezug auf die erste ferromagnetische Schicht 116.

Auf die Kopplungsschicht 118 wird die zweite ferromagnetische Schicht 120 abgeschieden, welche aus einer CoFeB-Legierung, typischerweise Co40Fe40B20, hergestellt ist. Die Schichtdicke der zweiten ferromagnetischen Schicht 120 wird dabei so gewählt, dass die magnetischen Momente der abgeschiedenen, noch nicht gepinnten ferromagnetischen Schichten 116, 120 ein gewünschtes Verhältnis annehmen. Vorteilhaft kann dieses Verhältnis, genauer der Quotient aus dem magnetischen Moment M1 der ersten ferromagnetischen Schicht 116 und dem magnetischen Moment M2 der zweiten ferromagnetischen Schicht 120, M1/M2 einen Wert zwischen 1,7 und 2,3, typisch 2,0 annehmen. Bezogen auf die oben genannten Materialzusammensetzungen der ferromagnetischen Schichten 116, 120 entspricht dies einem Verhältnis oder Quotienten der physikalischen Dicke D1 der ersten ferromagnetischen Schicht 116 und der physikalischen Dicke D2 der zweiten ferromagnetischen Schicht 120, D1/D2 in einem Bereich zwischen 1,36 und 1,94, typisch 1,6.

Die antiferromagnetische Schicht 114, die erste ferromagnetische Schicht 116, die Kopplungsschicht 118 und die zweite ferromagnetische Schicht 120 bilden zusammen einen Referenzschichtstapel 126. Die beiden ferromagnetischen Schichten 116, 120 können zur Erzielung der verschiedenen magnetischen Momente unterschiedliche Materialzusammensetzungen und/oder unterschiedliche Schichtdicken aufweisen. Hierzu ist die erste ferromagnetische Schicht 116 mit der Dicke Δl1 und die ferromagnetische Schicht 120 mit der Dicke Δl2 dargestellt, wobei eine verringerte Dicke ein herabgesetztes magnetisches Moment indiziert.

Auf den Referenzschichtstapel 126 bzw. auf die Oberseite der zweiten ferromagnetischen Schicht 120 wird des Weiteren eine Barriereschicht 122 in Form einer nichtleitenden Schicht aus MgO aufgebracht, wobei deren Dicke so gewählt ist, dass der magnetoelektrische Tunneleffekt, welcher typischerweise zwischen 20% und 200% liegt, und der Tunnelwiderstand des Gesamtschichtstapels, welcher typischerweise zwischen 100 $\Omega$ und 30 k$\Omega$ liegen kann, für die betreffende Anwendung optimiert sind. Auf die Barriereschicht 122 wird schließlich eine dritte ferromagnetische Schicht 124 aufgebracht, welche CoFe, Co oder NiFe enthält, wobei zusätzlich ein oder mehrere weitere Elemente einlegiert sein können, beispielsweise B. Die dritte ferromagnetische Schicht 124 wird so ausgestaltet, dass der TMR-Effekt maximal wird.

Auf der dritten ferromagnetischen Schicht 124 können gegebenenfalls noch weitere ferromagnetische Schichten mit gleichen oder unterschiedlichen Materialzusammensetzungen oder Dicken aufgebracht sein, sodass die magnetischen Eigenschaften der dritten elektromagnetischen Schicht 124, ggf. einschließlich der weiteren ferromagnetischen Schichten, als Detektionsschicht optimiert werden können.

Weiterhin können auf der Schichtstruktur 100 eine oder mehrere nichtmagnetische, metallische Abschlussschichten bzw. Deckschichten 128 vorgesehen sein, um die Schichtstruktur 100 gegenüber Umwelteinflüssen bzw. darüber liegenden benachbarten Elementen abzugrenzen.

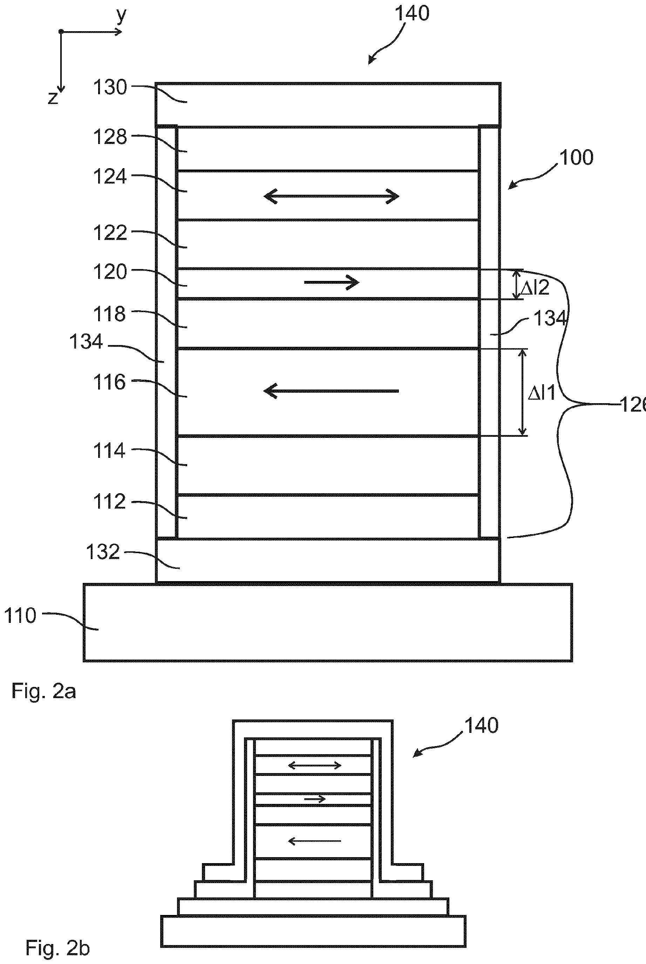

In der Fig. 2a ist ein gegenüber dem Schichtstruktur 100 der Fig. 1 ergänzte Schichtstruktur als Ausführungsform eines TMR-Elements 140 für eine erfindungsgemäße Anordnung dargestellt. Diese weist direkt auf dem Substrat 110 aufbauend eine Basiselektrodenschicht 132 und eine abschließende Deckelektrodenschicht 130 auf, sowie eine Deckschicht 128. Die Elektroden 130, 132 dienen zum elektrischen Anschluss des TMR-Elements z.B. für einen Anschluss in einer Messbrückenkonfiguration eines Magnetfeldsensors 10. Aufgrund der Elektrodenkonfiguration in Z-Richtung senkrecht zum Substrat 110 kann die Schichtstruktur 100 als TMR-Element 140 ausgeführt sein, eine seitliche Elektrodenkonfiguration kann auch ein GMR-Element bereitstellen.

Eine Isolationsschicht 134 überdeckt die Seitenflächen des TMR-Elements 140, so dass beim Aufbau eine definierte Schichtenreihenfolge und eine seitliche Abgrenzung zu benachbarten Schichtstrukturen ermöglicht werden.

Die genannten Schichten 114-124 können auch in umgekehrter Reihenfolge zwischen Deckschicht 128 und Saatschicht 112 auf dem Substrat 110 aufgebracht werden, d.h. beginnend mit der dritten ferromagnetischen Schicht 124 und abschließend mit der antiferromagnetischen Schicht 114, bzw. einer weiteren Deckschicht 128 und einer Basiselektrode 132.

Die Saatschicht 112 kann gleichfalls als unterer elektrischer Anschlusspunkt einer Basiselektrode 132 genutzt werden, alternativ kann die Basiselektrode 132 separat und vertikal benachbart zur Saatschicht 112 direkt auf dem Substrat 110 aufgebaut sein. Auf der Deckschicht 128 kann eine Abschlusselektrode 130 als oberer Anschlusspunkt der Schichtstruktur aufgebracht werden. Somit kann ein elektrischer Strom vertikal durch die Schichtstruktur geführt werden, so dass die Schichtstruktur als magnetoresistiver Widerstand mit einer entsprechend der magnetischen Ausrichtung der beiden ferromagnetischen Schichten definierten magnetischen Vorzugsrichtung ausgestattet ist. Die hieraus resultierende magnetoresistive Widerstandsschichtanordnung kann in Magnetfeldsensoranordnungen oder in magnetischen Speicheranordnungen mit hohen Sensitivitätsanforderungen genutzt werden.

In der Fig. 2b ist verkleinert das in der Fig. 2a dargestellte TMR-Element 140 dargestellt, wobei eine weitergehende Isolationsschicht 134 das TMR-Element 140 einkapselt und gegenüber benachbarten Strukturen auf dem Substrat 110 isoliert und passiviert.

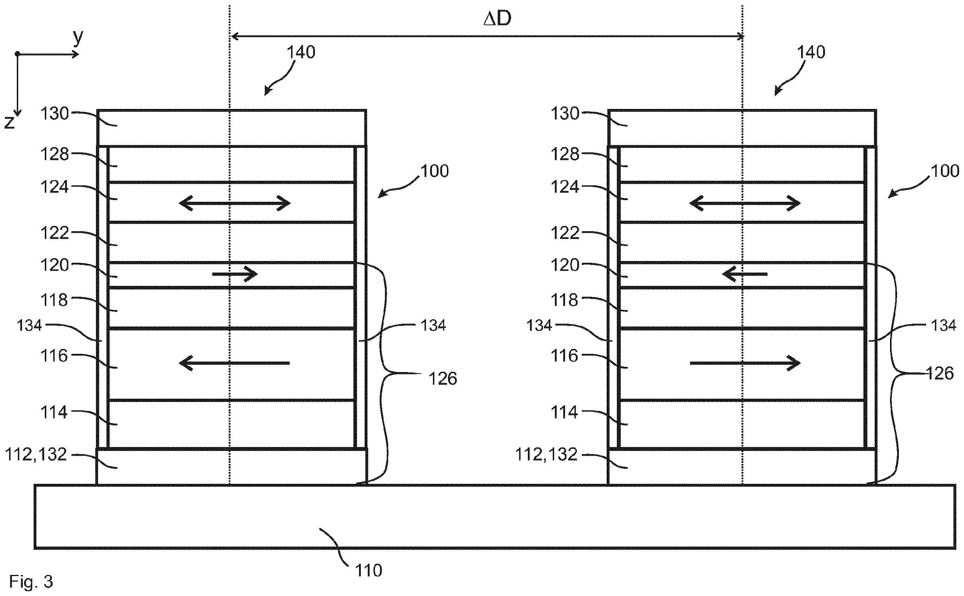

Fig. 3 stellt schematisch eine Ausführungsform einer Anordnung zweier benachbarter TMR-Elemente 140 mit einem Abstand der Mittelachsen im Größenbereich von 5 $\mu$m bis 50 $\mu$m dar, wobei jedes TMR-Element 140 im Wesentlichen der in Fig. 2a dargestellten Ausführung entspricht. Allerdings ist die Basiselektrode 132 als leitfähige Saatschicht 112 ausgeführt, so dass die Saatschicht 112 gleichzeitig zum elektrischen Anschluss des TMR-Elements 140 dient. Zur Anwendung in einem Magnetfeldsensor sind abweichende Pinningrichtungen von magnetoresistiven Widerständen einer Messbrücke erforderlich, die zur Homogenisierung des Widerstandsverhaltens idealerweise identisch aufgebaut und räumlich eng benachbart sind. Dies ist in Fig. 3 dadurch erreicht, dass der Mittenabstand $\Delta D$ der Referenzschichtstapel 126 zwischen 5 $\mu$m bis 50 $\mu$m beträgt, und die Pinningrichtungen der benachbarten Referenzschichtstapel 126 entgegengesetzt, d.h. um 180° antiparallel ausgerichtet sind. Es können auch geringfügige Abweichungen um +/- 20° von einer 180° Abweichung als im Wesentlichen antiparallel angenommen werden. Somit verhalten sich die elektrischen Widerstände der beiden Stapel bei einem externen Magnetfeld gegenläufig.

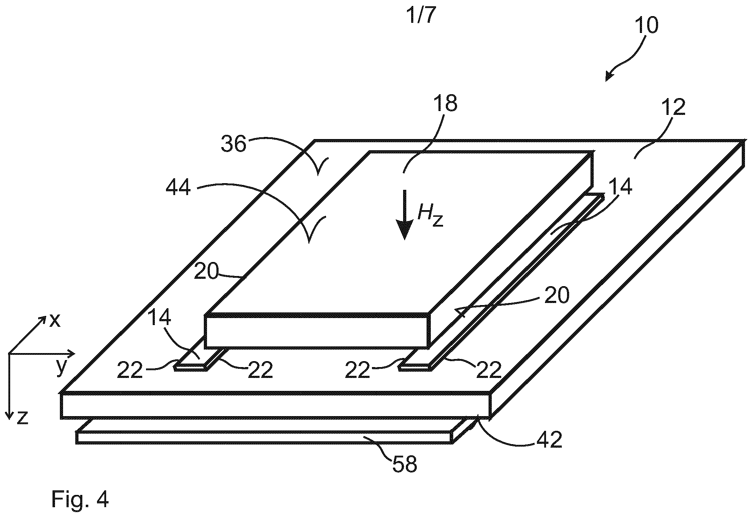

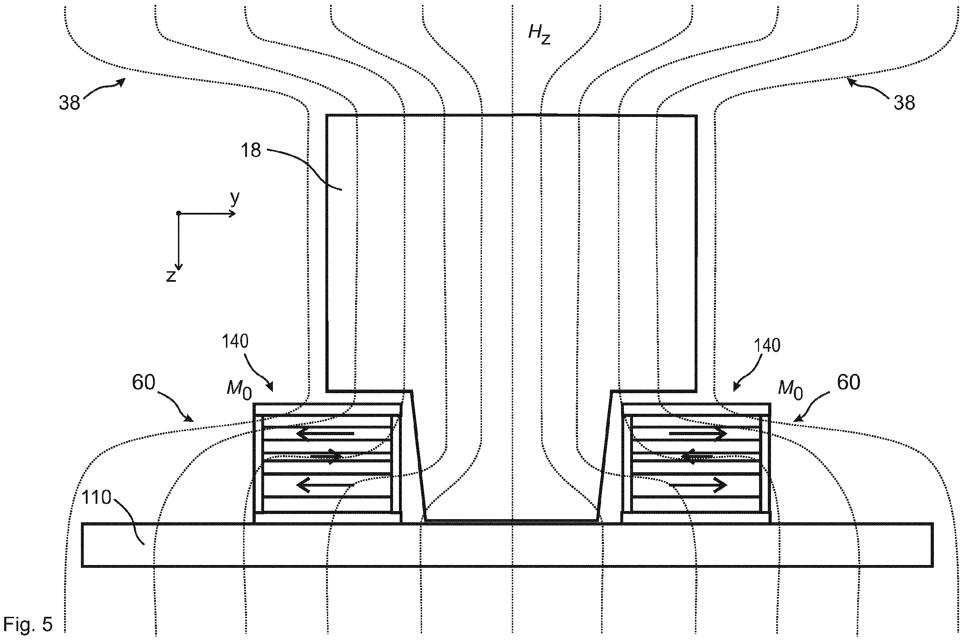

Damit die beiden Pinningrichtungen verschieden ausgerichtet werden können, kann vorteilhaft temporär ein weichmagnetisches Strukturierungselement 18 zwischen die beiden TMR-Elemente 140 eingebracht und in Z-Richtung von einem Vorbehandlungsmagnetfeld Hz durchflutet werden, dies ist perspektivisch in Fig. 4 und schematisch in einer Seitenansicht in Fig. 5 dargestellt.

Gemäß einem beispielhaften Verfahren zur Herstellung einer erfindungsgemäßen Schichtstruktur kann die Schichtstruktur 100 einem Pinning-Prozess unterzogen werden. Hierzu wird die Schichtstruktur 100 auf eine Temperatur oberhalb der Blocking-Temperatur der Schichtstruktur 100 erwärmt, vorzugsweise auf mehr als 260°C, typisch 280°C. Die Schichtstruktur 100 wird dann einem Vorbehandlungsmagnetfeld Hz mit einer relativ kleinen Magnetfeldstärke von nicht mehr als 130 mT, bevorzugt nicht mehr als 100 mT ausgesetzt, wobei die Feldlinien des hieraus abgeleiteten, durch Strukturierungselemente gestreutes Pinningfelds M0 parallel zu den Oberflächen der Schichtstruktur 100 verlaufen.

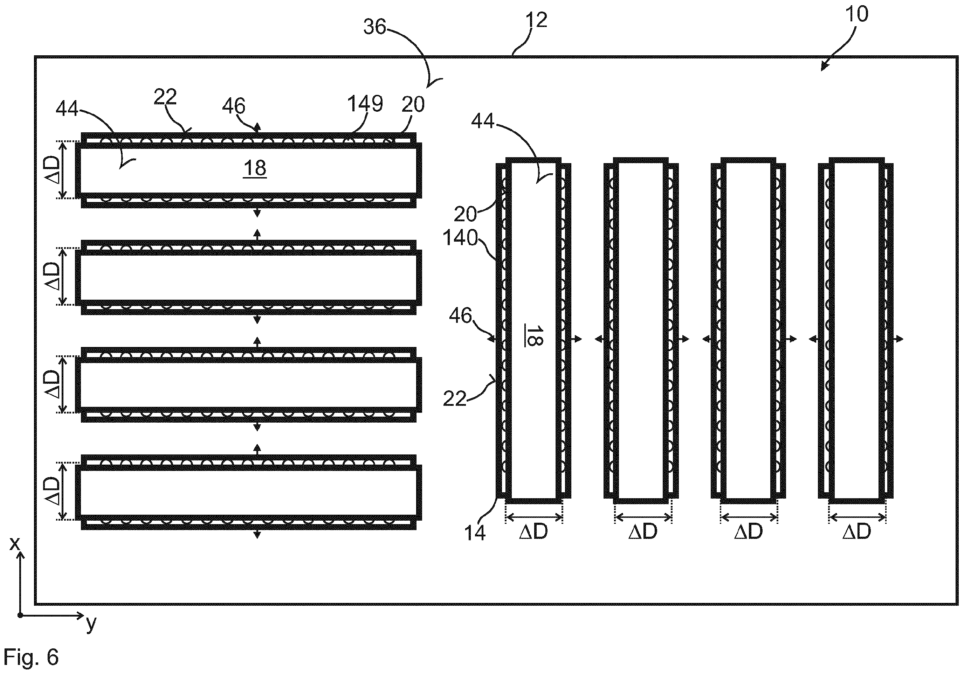

Das Pinning der Schichtstrukturen kann in besonders vorteilhafter Weise mithilfe von einem oder mehreren weichmagnetischen Strukturierungselementen 18 erfolgen. Eine entsprechende Magnetfeldsensoranordnung ist perspektivisch in Fig. 4 und schematisch in einer Seitendarstellung mit einer skizzenhaften Darstellung des Feldstärkenverlaufs des Pinningfelds in Fig. 5 dargestellt. Ein magnetoresistiver Magnetfeldsensor 10, wie er in Draufsicht in Fig. 6 mit aufgebrachten Strukturierungselementen 18 gezeigt ist, umfasst mehrere Widerstandselemente 14, welche durch eine jeweilige Schichtstruktur 100 gemäß Fig. 1 gebildet sind. Der Magnetfeldsensor 10 umfasst ein Halbleiterchipsubstrat oder Substrat 12, auf dem Widerstandselemente 14 angeordnet sind. Die Widerstandselemente können zu einer Wheatstone-Messbrücke verschaltet werden. Zur magnetischen Vorausrichtung, dem sogenannten Pinnen der ferromagnetischen Schichten der Widerstandselemente 14, wird ein Vorbehandlungsmagnetfeld Hz 38 eingesetzt, das senkrecht zur Oberfläche 36 des Substrats 12 ausgerichtet ist.

Das Magnetfeld 38 wird von einem nicht dargestellten Magnetpol ausgesendet, durchdringt das Substrat 12 und wird von einer ebenfalls nicht dargestellten Gegenpoloberfläche 58, die unterhalb des Substrats 12 angeordnet ist, wieder aufgenommen. Das Vorbehandlungsmagnetfeld Hz 38 dringt senkrecht in ein weichmagnetisches Strukturierungselement 18 ein und wird dort konzentriert geführt, wobei es als Pinningfeld M0 60, d.h. als inhomogenes Streufeld rechtwinklig von einer Oberfläche 44 des Strukturierungselements 18 und im Wesentlichen parallel zur Oberfläche des Substrats 110 austritt.

Wie in Fig. 5 skizzenhaft veranschaulicht führt das Strukturierungselement 18 das Vorbehandlungsmagnetfeld Hz 38 derart, dass es an Berandungskanten 20 parallel zur Substratoberfläche 36 als Pinningfeld M0 60 austritt und die Widerstandselemente 14, die als TMR-Elemente 140 ausgeführt sind, parallel zur Oberfläche des Substrates 110 durchdringt. Ein verbessertes Durchdringen der Widerstandselemente 14 wird insbesondere dadurch erreicht, dass eine Temperatur oberhalb der Blocking-Temperatur der antiferromagnetischen Schichten der Widerstandselemente 14 eingestellt ist, sodass eine verbesserte Flussführung durch die Widerstandselemente 14 erfolgen kann.

Die Berandungskanten 20 des Strukturierungselements 18 überlappen in einer vorteilhaften Ausführung die Berandungskanten 22 der Widerstandselemente 14. Die Widerstandselemente 14 werden so in ihrer gesamten Breite von Magnetfeldern durchsetzt, die auch eine Komponente parallel zur Substratoberfläche 36 aufweisen. Letztlich werden die magnetischen Feldlinien durch das Substrat 12 auf die Gegenpoloberfläche 58 gelenkt, sodass verschiedene Pinningrichtungen in Abhängigkeit der Ausrichtung der Berandungskanten 20 der Strukturierungselemente 18 auf dem Substrat 12 einstellbar sind.

In Fig. 6 ist die Herstellung eines komplexen Winkelsensors bestehend aus zwei Wheatstone-Messbrücken zur Messung zweier rechtwinkliger Magnetfeldkomponenten X und Y eines Magnetfeldsensors 10 dargestellt. Zur verbesserten Veranschaulichung ist die Verdrahtungsebene nicht dargestellt, welche die Widerstandselemente in Serienschaltungen bzw. in Parallelschaltungen z.B. zur Ausbildung einer Wheatstone-Messbrücke, verbindet. Ebenso sind die Terminals bzw. die Pads zur Kontaktierung mit der Außenwelt nicht dargestellt. In Fig. 6 ist der Pinning-Schritt eines Magnetfeldsensors 10 dargestellt, wobei auf einer Substratoberfläche 36 eines Substrats 12 eine Vielzahl von Widerstandselementen 14, z.B. TMR-Widerstandselemente 14 entsprechend einer Anordnung von Schichtstrukturen 140 von Fig. 2, angeordnet ist. Diese sind zumindest für die paarweise abgewinkelten - hier antiparallel gepinnten TMR-Elementen 140 in einem Mittenabstand $\Delta D$ zueinander angeordnet. In diesen Beabstandungsbereichen ΔD sind teilweise überlappend zu den Berandungskanten 22 der Widerstandelemente 14 weichmagnetische Strukturierungselemente 18 z.B. aus NiFe aufgebracht, deren Berandungskanten 20 die Berandungskanten 22 der Widerstandelemente 14 zumindest teilweise überdecken. Durch Aufbringen eines senkrecht zur Substratoberfläche 36 gerichteten Magnetfeldes werden, wie mit den kleinen Pfeilen angedeutet, Berandungskanten-Streufelder 46 der Strukturierungselemente 18 erzeugt, die ein Pinnen der Widerstandelemente 14 durchführen. Die Strukturierungselemente 18 können nach dem Pinnen durch ein materialabtragenden Verfahren wieder vom Substrat 110 entfernt werden.

Fig. 6 demonstriert, dass aufgrund dieser Erfindung komplexe Sensoren mit einer Vielzahl von Pinningrichtungen hergestellt werden können, unter Verwendung thermisch robuster Antiferromagnete wie PtMn oder NiMn und thermisch robuster Schichtstapel mit einer antiferromagnetisch gekoppelten Referenzschicht. Alle auf einem Wafersubstrat gebauten Sensoren können in einem Schritt gleichzeitig in beliebige Richtungen über lange Zeit gepinnt werden, was eine wirtschaftliche Umsetzung auch bei Verwendung von Antiferromagneten, die ein langes Pinning zur Ausprägung der bevorzugten L1o Phase erfordern, ermöglicht.

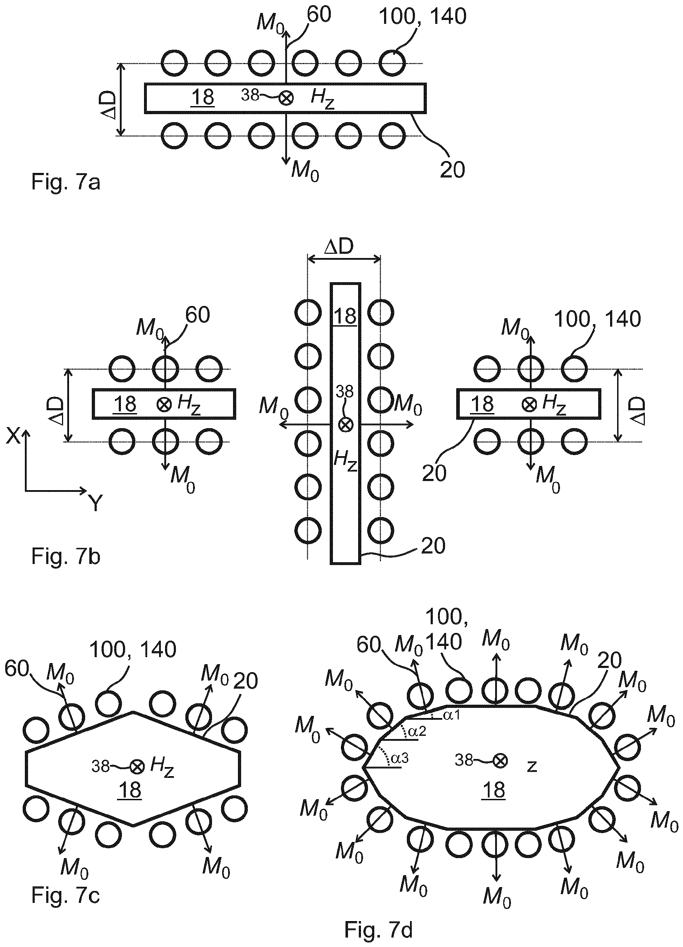

In der Fig. 7 sind verschiedene Anordnungen von als TMR-Elemente 140 ausgebildeten Schichtstrukturen 100 dargestellt. Um unterschiedliche Pinningrichtungen M0 während der Herstellung auszubilden, wird temporär ein weichmagnetisches Strukturierungselement 18 in den Abstand zwischen einer Vielzahl von paarweise angeordneten Schichtstrukturen 100 eingebracht. Das Strukturierungselement 18 wird bei einer Temperatur über der Blockingtemperatur mit einem senkrecht zur Stapelebene der Schichtstrukturen 100 ausgerichteten Vorbehandlungsmagnetfeld Hz 38 beaufschlagt, wobei sich ein Streumagnetfeld rechtwinklig wegweisend von den umlaufenden Kanten des Strukturierungselements als Pinningfeld M0 60 ausbildet. Das Pinningfeld M0 60 ist in der Stapelebene der Strukturierungselemente ausgerichtet und magnetisiert, d.h. pinnt die korrespondierten ferromagnetischen Schichten 116 und damit auch die Schicht 120 der Schichtstrukturen 100 in jeweils unterschiedlicher Richtung.

In Fig. 7a ist eine Reihe von 6 jeweils paarweise mit einem Mittenabstand ΔD beabstandeter TMR-Elemente 140 schematisch gezeigt, die mittels eines rechteckförmigen Strukturierungselement 18 entgegengesetzt gepinnt werden. In einer Reihenschaltung der TMR-Elemente können hierdurch zwei Brückenwiderstände einer Halbbrücke eines Magnetfeldsensors 10 mit entgegengesetzter Magnetfeldsensitivität gebildet werden.

Fig. 7b zeigt schematisch eine Mehrzahl von Anordnungen von TMR-Elementen 140, die beispielsweise für einen magnetresistiven Winkelsensor eingesetzt und hierzu verschaltet werden können. Dabei kann eine Mehrzahl von paarweisen Anordnungen von TMR-Elementen der Fig. 7a um 90° versetzt zur Ausbildung von in einer X- Richtung und Y-Richtung sensitiven Brückenwiderständen eingesetzt werden. Entsprechend sind die zwischen den TMR-Elementen 140 temporär eingebrachten Strukturierungselemente um 90° versetzt zueinander, um Pinningfelder M0 60 in X- bzw. Y-Richtung bereitzustellen.

Die Fig. 7c und Fig. 7d zeigen weitere Ausführungen von Anordnungen von Schichtstrukturen 100 als TMR-Elemente 140, zwischen denen ein Strukturierungselement 18 mit abgewinkelten Berandungskanten 20 angeordnet ist. In der Fig. 7c ist das Strukturierungselement 18 als Sechseck ausgeformt, wobei zwei Paare von um 180° versetzten Pinningrichtungen bereitgestellt werden kann. Die Paare können ein um 90°, 60°, 45°, 36°, 30°, 18° oder 15° abweichende Pinningrichtung aufweisen.

Das Strukturierungselement der Fig. 7d ist als 14-Eck ausgebildet, wobei die beiden spiegelsymmetrisch gegenüberliegenden Berandungskanten 20 drei symmetrische Winkelstufen $\alpha 1$, $\alpha 2$ und $\alpha 3$ von -60°, -45°, 30°, 0°, 30°, 45° und 60° aufweisen. Insoweit können beispielsweise zur Oberwellenfilterung in Reihe geschaltete TMR-Elemente unterschiedliche Pinningrichtungen insbesondere im Einsatz als Winkelsensor aufweisen. Die dargestellte Anzahl von TMR-Elementen 140 für jede Widerstandsanordnung ist schematisch, in der Regel ist die Anzahl von TMR-Elementen in jedem Brückenwiderstand deutlich höher, als dargestellt.

Grundsätzlich kann das gleichzeitige Pinnen einer erfindungsgemäßen Anordnung von Schichtstruktur 100 (Fig. 1) auch auf jede andere geeignete Weise erfolgen. Auch kann die Anordnung von weichmagnetischen Strukturierungselementen 18 auch als von oben kurzfristig in die Substratstruktur eintauchender Stempel ausgebildet sein.

**Bezugszeichenliste**

10      Magnetfeldsensor
12      Substrat
14      Widerstandselement
18      weichmagnetisches Strukturierungselement
20      Berandungskante des Strukturierungselements
22      Berandungskante des Widerstandselements
36      Substratoberfläche
38      Vorbehandlungsmagnetfeld
42      Substratunterseite
44      Oberfläche des Strukturierungselements
46      Berandungskanten-Streufeld
58      Gegenpoloberfläche
60      Pinningfeld

100     Schichtstruktur
110     Substrat
112     Saatschicht
114     antiferromagnetische Schicht

116     erste ferromagnetische Schicht
118     Kopplungsschicht
120     zweite ferromagnetische Schicht
122     Barriereschicht
124     dritte ferromagnetische Schicht, Detektionsschicht
126     Referenzschichtstapel
128     Deckschicht
130     Abschlusselektrode
132     Basiselektrode
134     Isolationsschicht

140     TMR-Element
$Hz$     Vorbehandlungsmagnetfeld in Z-Richtung
$\Delta l1$     Breite der ersten ferromagnetischen Schicht
$\Delta l2$     Breite der zweiten ferromagnetischen Schicht
$\Delta D$     Mittenabstand benachbarter Schichtstrukturen
$M0$     Pinningfeld
$\alpha1$     erster Seitenflächenwinkel
$\alpha2$     zweiter Seitenflächenwinkel
$\alpha3$     dritter Seitenflächenwinkel

**Patentansprüche**

1. Anordnung von zumindest zwei benachbart angeordneten und identisch aufgebauten Schichtstrukturen (100) für einen magnetoresistiven Magnetfeldsensor (10), jede Schichtstruktur (100) zumindest umfassend eine antiferromagnetische Schicht (114), eine erste ferromagnetische Schicht (116) mit einem ersten magnetischen Moment, wobei zwischen der antiferromagnetischen Schicht (114) und der ersten ferromagnetischen Schicht (116) eine Austauschkopplung besteht, und eine zweite ferromagnetische Schicht (120) mit einem zweiten magnetischen Moment, wobei die zweite ferromagnetische Schicht (120) über eine zwischen der ersten und der zweiten ferromagnetischen Schicht (116, 120) angeordneten nichtmagnetischen Kopplungsschicht (118) mit der ersten ferromagnetischen Schicht (116) antiparallel gekoppelt ist, wobei die Magnetisierungen der korrespondierten ersten und korrespondierten zweiten ferromagnetischen Schichten (116, 120) der mit einem Mittenabstand $\Delta D$ von 50 $\mu$m oder weniger benachbart angeordneten Schichtstrukturen (100) voneinander abweichen, insbesondere im Wesentlichen entgegengesetzt zueinander ausgerichtet sind, **dadurch gekennzeichnet, dass** die abweichenden Magnetisierungen aller korrespondierenden ferromagnetischen Schichten (116, 120) der benachbarten Schichtstrukturen (100) in einem Pinningschritt gleichzeitig eingestellt wurden.

2. Anordnung von Schichtstrukturen (100) nach Anspruch 1, **dadurch gekennzeichnet, dass** zumindest drei, insbesondere vier oder mehr Schichtstrukturen (100), nur durch einen Zwischenraum, oder ein weichmagnetisches Strukturierungselement, voneinander getrennt, benachbart zueinander angeordnet sind, und deren Magnetisierungen voneinander abweichen, wobei insbesondere die Magnetisierungen von paarweise gegenüberliegenden Schichtstrukturen (100) im Wesentlichen entgegengesetzt zueinander ausgerichtet sind, und wobei insbesondere die Magnetisierungen von verschiedenen Paaren von Schichtstrukturen (100) um bevorzugt 90°, 60°, 45°, 36°. 30°, 18° oder 15° abgewinkelt sind.

3. Anordnung von Schichtstrukturen (100) nach Anspruch 1 oder 2, **dadurch gekennzeichnet, dass** der Mittenabstand $\Delta D$ der benachbarten Schichtstrukturen (100) 20 $\mu$m oder weniger, insbesondere 10 $\mu$m oder weniger beträgt.

4. Anordnung von Schichtstrukturen (100) nach einem der vorhergehende Ansprüche, **dadurch gekennzeichnet, dass** in jeder Schichtstruktur (100) der Quotient aus dem ersten und dem zweiten magnetischen Moment jeder Schichtstruktur (100) ungleich 1 ist, insbesondere zwischen 1,7 und 2,3 beträgt.

5. Anordnung von Schichtstrukturen (100) nach einem der vorhergehende Ansprüche, **dadurch gekennzeichnet, dass** jede Schichtstruktur (100) eine dritte ferromagnetische Schicht (124) umfasst, welche an der Kopplungsschicht (118) abgewandten Seite der zweiten ferromagnetischen Schicht (120) angeordnet ist, wobei insbesondere zwischen der zweiten und dritten ferromagnetischen Schicht (120, 124) eine nichtmagnetische, insbesondere nichtleitende Barriereschicht (122), bevorzugt aus MgO, angeordnet ist, wobei bevorzugt jede Schichtstruktur (100) zumindest eine nichtmagnetische, insbesondere metallische Deckschicht (128) umfasst, welche an der der zweiten ferromagnetischen Schicht (120) abgewandten Seite der dritten ferromagnetischen Schicht (124) angeordnet ist.

6. Anordnung von Schichtstrukturen (100) nach einem der vorhergehenden Ansprüche, **dadurch gekennzeichnet, dass** in jeder Schichtstruktur (100) die erste ferromagnetische Schicht (116) aus einer ersten ferromagnetischen Materialzusammensetzung und die zweite ferromagnetische Schicht (120) aus einer zweiten ferromagnetischen Materialzusammensetzung besteht, wobei die erste ferromagnetischen Materialzusammensetzung von der zweiten ferromagnetischen Materialzusammensetzung verschieden ist.

7. Anordnung von Schichtstrukturen (100) nach Anspruch 6, **dadurch gekennzeichnet, dass** in jeder Schichtstruktur (100) die erste ferromagnetischen Materialzusammensetzung eine CoFe-Legierung ist, wobei insbesondere der Stoffmengenanteil an Fe zwischen 5 und 15%, bevorzugt 10% beträgt.

8. Schichtstruktur (100) nach Anspruch 6 oder 7, **dadurch gekennzeichnet, dass** in jeder Schichtstruktur (100) die zweite ferromagnetische Materialzusammensetzung eine CoFeB-Legierung ist, wobei im Rahmen einer jeweiligen Toleranzabweichung der Stoffmengenanteil an Co und Fe jeweils 40% und der Anteil an B 20% beträgt, wobei die Toleranzabweichung umfasst, dass ein jeweiliger Anteil um nicht mehr als 5 Prozentpunkte, bevorzugt um nicht mehr als 2,5 Prozentpunkte von dem jeweiligen genannten Wert für den Anteil abweicht.

9. Anordnung von Schichtstrukturen (100) nach einem der vorhergehenden Ansprüche, **dadurch gekennzeichnet, dass** in jeder Schichtstruktur (100) die erste ferromagnetische Schicht (116) eine erste Schichtdicke $\Delta l1$ und die zweite ferromagnetische Schicht (120) eine zweite Schichtdicke $\Delta l2$ aufweist, wobei der Quotient $\Delta l1/ \Delta l2$ aus der ersten und der zweiten Schichtdicke zwischen 1,2 und 2,5 beträgt.

10. Anordnung von Schichtstrukturen (100) nach Anspruch 9, **dadurch gekennzeichnet, dass** in jeder Schichtstruktur (100) die erste Schichtdicke $\Delta l1$ zwischen 0,5 nm und 2,0 nm, bevorzugt 1,2 nm, beträgt und die zweite Schichtdicke $\Delta l2$ derart gewählt ist, dass der Quotient aus dem ersten und dem zweiten magnetischen Moment zwischen 1,7 und 2,3 beträgt.

11. Anordnung von Schichtstrukturen (100) nach einem der vorhergehenden Ansprüche, **dadurch gekennzeichnet, dass** in jeder Schichtstruktur (100) die Kopplungsschicht (118), insbesondere ausschließlich, aus Ruthenium besteht und eine Dicke zwischen 0,35 nm und 0,85 nm, bevorzugt 0,5 nm aufweist.

12. Anordnung von Schichtstrukturen (100) nach einem der vorhergehenden Ansprüche, **dadurch gekennzeichnet, dass** in jeder Schichtstruktur (100) die antiferromagnetische Schicht (114) eine Manganlegierung, insbesondere Iridium-Mangan (IrMn), Platin-Mangan (PtMn), Nickel-Mangan (NiMn), Eisenmangan (FeMn) oder ein Legierungsgemisch hiervon ist, wobei bevorzugt die Manganlegierung, insbesondere Platin-Mangan (PtMn), Nickel-Mangan (NiMn) in einer in der geordneten L1o Phase vorliegen.

13. Anordnung von Schichtstrukturen (100) nach einem der vorhergehenden Ansprüche, **dadurch gekennzeichnet, dass** die Anordnung von Schichtstrukturen (100) auf einem Substrat (110) angeordnet sind, wobei jede Schichtstruktur (100) als ein TMR-Element (140) mit einer unteren Basiselektrode (132), bevorzugt einer als Saatschicht (112) ausgebildeten Basiselektrode (132) und einer oberen Abschlusselektrode (130) ausgebildet ist, wobei in der ersten ferromagnetischen Schicht (116) eine Magnetisierung in einer Pinningrichtung eingeprägt ist, und sich in der zweiten ferromagnetischen Schicht (120) eine hierzu antiparallel ausgerichtete Magnetisierung einstellt.

14. Magnetoresistiver Magnetfeldsensor (10), umfassend ein Substrat (110), eine Anordnung von zumindest zwei oder mehreren auf dem Substrat (110) benachbart angeordneten Schichtstrukturen (100) nach einem der vorhergehenden Ansprüche 1 bis 13, und zumindest ein zumindest temporär einbringbares und benachbart oder teilweise überlappend zu einer jeweiligen Schichtstruktur (100), bevorzugt überlappend zwischen zwei oder mehreren benachbart angeordneten Schichtstrukturen (100) angeordnetes weichmagnetisches Strukturierungselement (18), wobei das Strukturierungselement (18) dazu ausgebildet und angeordnet ist, ein Vorbehandlungsmagnetfeld Hz (38), welches in das bzw. die Strukturierungselemente (18) eindringt, derart zu beeinflussen, dass zumindest in der ersten ferromagnetischen Schicht (116) benachbarter Schichtstrukturen (100) abweichend ausgerichtete Magnetfeldkomponenten als Streumagnetfeld des Strukturierungseiements (18) als Pinningfeld M0 (60) wirksam werden, welche parallel zu einer Oberfläche der Schichtstruktur (100) verlaufen, wobei bevorzugt das Vorbehandlungsmagnetfeld Hz (38) senkrecht zur Oberfläche des Substrats (110) in das Strukturierungselement (18) einkoppelbar ist.

15. Verfahren zum Herstellen einer Anordnung von Schichtstrukturen (100) nach einem der vorhergehenden Ansprüche 1 bis 13, mit den Schritten: Aufbringen der Schichten auf ein Substrat (110) in der genannten, oder in umgekehrter Reihenfolge, zwischen einer Deckschicht (128) und einer Saatschicht (112), Erwärmen der Schichtstruktur (100) auf eine Temperatur oberhalb einer Blocking-Temperatur bei welcher die Austauschkopplung zwischen der antiferromagnetischen Schicht (114) und der ersten ferromagnetischen Schicht (116) aufgehoben ist, Einkoppeln eines, insbesondere senkrecht zur Oberfläche des Substrats (110) ausgerichteten, Vorbehandlungsmagnetfelds Hz (38) in die erwärmten Schichtstrukturen (100) zum gleichzeitigen Einstellen eines Pinningfelds M0 (60) mit abweichenden Magnetisierungsrichtungen zumindest der ersten ferromagnetischen Schicht (116) benachbarter Schichtstrukturen (110) zumindest während einer Zeitdauer, bei welcher die Temperatur der Schichtstruktur (100) größer als die Blocking-Temperatur ist, und Abkühlen der Schichtstruktur (100) auf eine Temperatur unterhalb einer Blocking-Temperatur.

**16.** Verfahren nach Anspruch 15, wobei die Anordnung der Schichtstrukturen (100) auf mindestens 260°C, bevorzugt 280°C, insbesondere mindestens 300°C erwärmt wird.

**17.** Verfahren nach Anspruch 15 oder 16, wobei die magnetische Flussdichte des eingekoppelten Vorbehandlungsmagnetfelds Hz (38) nicht mehr als 200 mT, bevorzugt nicht mehr als 100 mT beträgt.

**18.** Verfahren nach einem der Ansprüche 15 bis 17, wobei eine Zeitdauer, für welche das Vorbehandlungsmagnetfeld Hz (38) in die oberhalb der Blocking-Temperatur erwärmte Schichtstruktur (100) eingekoppelt wird, mindestens 1 h, bevorzugt mindestens 5 h, besonders bevorzugt mindestens 12 h beträgt.

**19.** Verfahren zum Herstellen eines magnetoresistiven Magnetfeldsensors (10) nach Anspruch 14, mit den Schritten: Herstellen der Anordnung von Schichtstrukturen (100) gemäß dem Verfahren nach einem der Ansprüche 16 bis 18, und zumindest temporäres Aufbringen des zumindest einen Strukturierungselements (18), wobei das Vorbehandlungsmagnetfeld Hz (38) über das Strukturierungselement (18) als Pinningfeld M0 (60) in die Schichtstrukturen (100) mit abweichenden Magnetisierungsrichtungen eingekoppelt wird, und wonach bevorzugt das Strukturierungselement (18) nach Abschluss des Pinnings wieder entfernt wird.

**20.** Verfahren nach Anspruch 19, wobei die Anordnung von zumindest zwei benachbarten und zueinander beabstandeten Schichtstrukturen (100) auf dem Substrat (110) aufgebracht wird und das Strukturierungselement (18) zwischen den Schichtstrukturen (100) zumindest temporär aufgebracht wird, und wobei das Vorbehandlungsmagnetfeld Hz (38) senkrecht zur Oberfläche des Substrats (110) in das Strukturierungselement (18) eingekoppelt wird, so dass ein vom Strukturierungselement (18) erzeugtes Streumagnetfeld als Pinningfeld M0 (60) im Wesentlichen parallel zur Oberfläche des Substrats (110) eine abweichende Ausrichtung des Pinningfelds M0 (60) benachbarter Schichtstrukturen (100) bereitstellt, dessen Ausrichtung von der Seitengeometrie des Strukturierungselements (18) abhängt, so dass die Ausrichtung des Pinningfelds M0 (60) der benachbarten Schichtstrukturen (100) voneinander abweichen, insbesondere im Wesentlichen entgegengesetzt ausgerichtet sind.

**Claims**

**1.** An arrangement of at least two adjacently arranged and identically constructed layer structures (100) for a magnetoresistive magnetic field sensor (10), each layer structure (100) comprising at least one antiferromagnetic layer (114), a first ferromagnetic layer (116) with a first magnetic moment, wherein exchange coupling is present between the antiferromagnetic layer (114) and the first ferromagnetic layer (116), and a second ferromagnetic layer (120) with a second magnetic moment, wherein the second ferromagnetic layer (120) is antiparallel coupled with the first ferromagnetic layer (116) via a non-magnetic coupling layer (118) arranged between the first and second ferromagnetic layers (116, 120), wherein the magnetisations of the corresponding first and corresponding second ferromagnetic layers (116, 120) of the layer structures (100) arranged adjacently with a centre-to-centre distance $\Box$D of 50 $\mu$m or less differs from one another, in particular is of substantially mutually opposed orientation, **characterised in that** the different magnetisations of all corresponding ferromagnetic layers (116, 120) of the adjacent layer structures (100) of the adjacent layer structures (100) were simultaneously established in one pinning step.

**2.** An arrangement of layer structures (100) according to Claim 1, **characterised in that** at least three, in particular four or more layer structures (100) are arranged adjacent one another, separated from one another merely by an interspace, or a soft magnetic patterning element, and the magnetisations thereof differ from one another, wherein in particular the magnetisations of pairwise opposing layer structures (100) are of mutually substantially opposing orientation, and wherein in particular the magnetisations of various pairs of layer structures (100) are angled by preferably 90°, 60°, 45°, 36°, 30°, 18° or 15°.

**3.** An arrangement of layer structures (100) according to Claim 1 or Claim 2, **characterised in that** the centre-to-centre distance $\Delta$D of the adjacent layer structure (100) amounts to 20 $\mu$m or less and in particular 10 $\mu$m or less.

**4.** An arrangement of layer structures (100) according to one of the preceding claims, **characterised in that** in each layer structure (100) the quotient of the first and second magnetic moment of each layer structure (100) is different from 1 and in particular amounts to between 1.7 and 2.3.

**5.** An arrangement of layer structures (100) according to one of the preceding claims, **characterised in that** each layer structure (100) comprises a third ferromagnetic layer (124), which is arranged on the side of the second ferromagnetic layer (120) remote from the coupling layer (118), wherein a non-magnetic, in particular non-conductive barrier layer (122), preferably of MgO, is arranged in particular between the second and third ferromagnetic layers (120, 124), wherein each layer structure (100) preferably comprises at least one non-magnetic, in particular metallic cover layer (128), which is arranged on the side of the third ferromagnetic layer (124) remote from the second ferromagnetic layer (120).

6. An arrangement of layer structures (100) according to one of the preceding claims, **characterised in that** in each layer structure (100) the first ferromagnetic layer (116) consists of a first ferromagnetic material composition and the second ferromagnetic layer (120) consists of a second ferromagnetic material composition, wherein the first ferromagnetic material composition is different from the second ferromagnetic material composition.

7. An arrangement of layer structures (100) according to Claim 6, **characterised in that** in each layer structure (100) the first ferromagnetic material composition is a CoFe alloy, wherein in particular the mole fraction of Fe amounts to between 5 and 15% and preferably 10%.

8. A layer structure (100) according to Claim 6 or Claim 7, **characterised in that** the second ferromagnetic material composition in each layer structure (100) is a CoFeB alloy, wherein, in the context of a respective tolerance deviation, the mole fraction of Co and Fe amounts in each case to 40% and the fraction of B amounts to 20%, wherein the tolerance deviation allows a respective fraction to deviate by no more than 5 percentage points and preferably by no more than 2.5 percentage points from the respective stated value for the fraction.

9. An arrangement of layer structures (100) according to one of the preceding claims, **characterised in that** the first ferromagnetic layer (116) in each layer structure (100) has a first layer thickness $\Delta l1$ and the second ferromagnetic layer (120) has a second layer thickness $\Box l2$, wherein the quotient $\Delta l1/\Delta l2$ of the first and second layer thicknesses amounts to between 1.2 and 2.5.

10. An arrangement of layer structures (100) according to Claim 9, **characterised in that** the first layer thickness $\Delta l1$ in each layer structure (100) amounts to between 0.5 nm and 2.0 nm and preferably 1.2 nm, and the second layer thickness $\Delta l2$ is selected such that the quotient of the first and second magnetic moments amounts to between 1.7 and 2.3.

11. An arrangement of layer structures (100) according to one of the preceding claims, **characterised in that** in each layer structure (100) the coupling layer (118) consists, in particular exclusively, of ruthenium and has a thickness of between 0.35 nm and 0.85 nm and preferably of 0.5 nm.

12. An arrangement of layer structures (100) according to one of the preceding claims, **characterised in that** in each layer structure (100) the antiferromagnetic layer (114) is a manganese alloy, in particular iridium-manganese (IrMn), platinum-manganese (PtMn), nickel-manganese (NiMn), iron-manganese (FeMn) or an alloy mixture thereof, wherein the manganese alloy, in particular platinum-manganese (PtMn) or nickel-manganese (NiMn), is present in an ordered $L1_0$ phase.

13. An arrangement of layer structures (100) according to one of the preceding claims, **characterised in that** the arrangement of layer structures (100) is arranged on a substrate (110), wherein each layer structure (100) takes the form of a TMR element (140) with a lower base electrode (132), preferably a base electrode (132) configured as a seed layer (112) and an upper terminating electrode (130), wherein in the first ferromagnetic layer (116) magnetisation is impressed in a pinning direction, and in the second ferromagnetic layer (120) a magnetisation oriented antiparallel thereto is established.

14. A magnetoresistive magnetic field sensor (10), comprising a substrate (110), an arrangement of at least two or more layer structures (100) arranged adjacently on the substrate (110), according to one of preceding Claims 1 to 13, and at least one at least temporarily introducible soft magnetic patterning element (18) arranged adjacent to or partially overlapping a respective layer structure (100), preferably overlapping between two or more adjacently arranged layer structures (100), wherein the patterning element (18) is configured and arranged to influence a pretreating magnetic field Hz (38), which penetrates into the patterning element(s) (18), in such a way that magnetic field components differently oriented at least in the first ferromagnetic layer (116) of adjacent layer structures (100) become active as a stray magnetic field of the patterning element (18) as a pinning field M0 (60), extending parallel to a surface of the layer structure (100), wherein the pretreating magnetic field Hz (38) is preferably injectable into the patterning element (18) perpendicular to the surface of the substrate (110).

15. A method for producing an arrangement of layer structures (100) according to one of preceding Claims 1 to 13, having the steps of: applying the layers to a substrate (110) in the stated or reverse sequence between a cover layer (128) and a seed layer (112), heating the layer structure (100) to a temperature above a blocking temperature at which the exchange coupling between the antiferromagnetic layer (114) and the first ferromagnetic layer (116) is cancelled out, injecting a pretreating magnetic field Hz (38) oriented perpendicular to the surface of the substrate (110), into the heated layer structures (100) simultaneously to establish a pinning field M0 (60) with different directions of magnetisation parallel to the layer plane at least of the first ferromagnetic layer (116) of adjacent layer structures (110) at least for a period during which the temperature of the layer structure (100) is greater than the blocking temperature, and cooling the layer structure (100) to a temperature below a blocking temperature.

16. A method according to Claim 15, wherein the arrangement of the layer structures (100) is heated to at least 260°C, preferably 280°C and in particular at least 300°C.

17. A method according to Claim 15 or 16, wherein the magnetic flux density of the injected pretreating magnetic field Hz (38) amounts to no more than 200 mT and preferably no more than 100 mT.

18. A method according to one of Claims 15 to 17, wherein a time period for which the pretreating magnetic field Hz (38) is injected into the layer structure (100) heated to above blocking temperature amounts to at least 1 h, preferably at least 5 h and particularly preferably at least 12 h.

19. A method for producing a magnetoresistive magnetic field sensor (10) according to Claim 14, having the steps of: producing the arrangement of layer structures (100) according to the method according to one of claims 16 to 18, and at least temporarily applying the at least one patterning element (18), wherein the pretreating magnetic field Hz (38) is injected into the layer structures (100) with different directions of magnetisation via the patterning element (18) as a pinning field M0 (60), and whereafter the patterning element (18) is preferably removed again after termination of the pinning.

20. A method according to Claim 19, wherein the arrangement of at least two adjacent, mutually spaced layer structures (100) is applied to the substrate (110), and the patterning element (18) applied at least temporarily between the layer structures (100), and wherein the pretreating magnetic field Hz (38) is injected into the patterning element (18) perpendicular to the surface of the substrate (110), such that a stray magnetic field generated by the patterning element (18) provides as a pinning field M0 (60) substantially parallel to the surface of the substrate (110) a different orientation of the pinning field M0 (60) of adjacent layer structures (100), the orientation of which is dependent on the side geometry of the patterning element (18), such that the orientation of the pinning field M0 (60) of the adjacent layer structures (100) differs from one another, in particular is substantially opposingly oriented.

**Revendications**

1. Ensemble d'au moins deux structures stratifiées (100) disposées de manière adjacente et de structure identique pour un capteur de champ magnétique magné-torésistif (10), chaque structure stratifiée (100) comprenant au moins une couche antiferromagnétique (114), une première couche ferromagnétique (116) avec un premier couple magnétique, sachant qu'il y a un couplage d'échange entre la couche antiferromagnétique (114) et la première couche ferromagnétique (116), et une deuxième couche ferromagnétique (120) avec un deuxième couple magnétique, sachant que la deuxième couche ferromagnétique (120) est couplée de manière antiparallèle à la première couche ferromagnétique (116) via une couche de couplage non magnétique (118) disposée entre la première et la deuxième couche ferromagnétique (116, 120), sachant que les magnétisations des premières et deuxièmes couches ferromagnétiques correspondantes (116, 120) des structures stratifiées (100) disposées de manière adjacente avec une distance centrale ΔD de 50 µm ou moins divergents les unes des autres, sont en particulier orientées essentiellement opposée les unes aux autres, **caractérisé en ce que** les magnétisations divergentes de toutes les couches ferromagnétiques correspondantes (116, 120) des structures stratifiées adjacentes (100) ont été réglées simultanément dans une étape d'épinglage (pinning).

2. Ensemble de structures stratifiées (100) selon la revendication 1, **caractérisé en ce qu'**au moins trois, en particulier quatre ou plus, structures stratifiées (100) sont disposées adjacentes les unes par rapport aux autres en étant séparées les unes des autres uniquement par un espace intermédiaire ou un élément de structuration magnétique doux et leurs magnétisations divergeant les unes des autres, sachant que les magnétisations en particulier de structures stratifiées (100) opposées par paire sont orientées essentiellement en sens opposé, et sachant qu'en particulier les magnétisations de différentes paires de structures stratifiées (100) sont inclinées de 90°, 60°, 45°, 36°, 30°, 18° ou 15°.

3. Ensemble de structures stratifiées (100) selon la revendication 1 ou 2, **caractérisé en ce que** la distance centrale ΔD des structures stratifiées (100) adjacentes s'élève à 20 µm ou moins, en particulier à 10 µm ou moins.

**4.** Ensemble de structures stratifiées (100) selon l'une des revendications précédentes, **caractérisé en ce que,** dans chaque structure stratifiée (100), le quotient du premier et du deuxième couple magnétique de chaque structure stratifiée (100) est différent de 1, en particulier qu'il se situe entre 1,7 et 2,3.

**5.** Ensemble de structures stratifiées (100) selon l'une des revendications précédentes, **caractérisé en ce que** chaque structure stratifiée (100) comprend une troisième couche ferromagnétique (124), laquelle est disposée sur le côté de la deuxième couche ferromagnétique (120) opposé à la couche de couplage (118), sachant qu'une couche barrière (122) non magnétique, en particulier non conductrice, de préférence en MgO, est en particulier disposée entre la deuxième et la troisième couche ferromagnétique (120, 124), sachant que chaque structure stratifiée (100) comprend de préférence au moins une couche de recouvrement non magnétique, en particulier métallique (128), laquelle est disposée sur le côté de la troisième couche ferromagnétique (124) opposé à la deuxième couche ferromagnétique (120).

**6.** Ensemble de structures stratifiées (100) selon l'une des revendications précédentes, **caractérisé en ce que,** dans chaque structure stratifiée (100), la première couche ferromagnétique (116) est constituée d'une première composition de matériau ferromagnétique et la deuxième couche ferromagnétique (120) d'une deuxième composition de matériau ferromagnétique, sachant que la première composition de matériau ferromagnétique est différente de la deuxième composition de matériau ferromagnétique.

**7.** Ensemble de structures stratifiées (100) selon la revendication 6, **caractérisé en ce que,** dans chaque structure stratifiée (100), la première composition de matériau ferromagnétique est un alliage CoFe, sachant que la fraction molaire de Fe est en particulier comprise entre 5 et 15% et s'élève de préférence à 10%.

**8.** Structure stratifiée (100) selon la revendication 6 ou 7, **caractérisée en ce que,** dans chaque structure stratifiée (100), la deuxième composition de matériau ferromagnétique est un alliage CoFeB, sachant que, dans le cadre d'un écart de tolérance respectif, la fraction molaire de Co et Fe est respectivement de 40% et la fraction de B de 20%, sachant que l'écart de tolérance comprend le fait qu'une fraction respective ne s'écarte pas de plus de 5 point de pourcentage, de préférence de plus de 2,5 points de pourcentage, de la valeur respective mentionnée pour la fraction.

**9.** Ensemble de structures stratifiées (100) selon l'une des revendications précédentes, **caractérisé en ce que,** dans chaque structure stratifiée (100), la première couche ferromagnétique (116) présente une première épaisseur de couche Δl1 et la deuxième couche ferromagnétique (120) une deuxième épaisseur de couche Δl2, sachant que le quotient Δl1/Δl2 de la première et de la deuxième épaisseur de couche se situe entre 1,2 et 2,5.

**10.** Ensemble de structures stratifiées (100) selon la revendication 9, **caractérisé en ce que,** dans chaque structure stratifiée (100), la première épaisseur de couche Δl1 est comprise entre 0,5 nm et 2,0 nm, de préférence est de 1,2 nm, et la deuxième épaisseur de couche Δl2 est sélectionnée de telle sorte que le quotient du premier et du deuxième couple magnétique se situe entre 1,7 et 2,3.

**11.** Ensemble de structures stratifiées (100) selon l'une des revendications précédentes, **caractérisé en ce que,** dans chaque structure stratifiée (100), la couche de couplage (118), est en particulier composée exclusivement de ruthénium et présente une épaisseur située entre 0,35 nm et 0,85 nm, de préférence de 0,5 nm.

**12.** Ensemble de structures stratifiées (100) selon l'une des revendications précédentes, **caractérisé en ce que,** dans chaque structure stratifiée (100), la couche antiferromagnétique (114) est un alliage de manganèse, en particulier d'iridium-manganèse (IrMn), de platine-manganèse (PtMn), de nickel-manganèse (NiMn), de fer-manganèse ou un mélange d'alliages de ces derniers, sachant que de préférence l'alliage de manganèse, en particulier le platine-manganèse (PtMn), le nickel-manganèse (NiMn) sont dans une phase ordonnée le $L1_0$.

**13.** Ensemble de structures stratifiées (100) selon l'une des revendications précédentes, **caractérisé en ce que** l'ensemble de structures stratifiées (100) est disposé sur un substrat (110), sachant que chaque structure stratifiée (100) est conçue sous forme d'un élément TMR (140) avec une électrode de base inférieure (132), de préférence une électrode de base (132) conçue sous la forme d'une couche d'ensemencement (112) et une électrode terminale supérieure (130), sachant qu'une magnétisation est imprégnée dans la première couche ferromagnétique (116) dans une direction d'épinglage, et qu'une magnétisation orientée de manière antiparallèle s'instaure dans la deuxième couche ferromagnétique (120).

**14.** Capteur de champ magnétique magnétorésistif (10), comprenant un substrat (110), un ensemble d'au moins deux ou plusieurs structures stratifiées (100) disposées de manière adjacente sur le substrat (110), selon l'une des revendications précédentes 1 à 13, et au moins un élément de structuration magnétique doux (18) pouvant être introduit au moins temporairement et disposé de manière adjacente ou en chevauchement partiel d'une structure stratifiée (100), de préférence en chevauchement entre deux ou plusieurs structures stratifiées (100) disposées de manière adjacente, sachant que l'élément de structuration (18) est conçu et disposé pour influencer un champ magnétique de prétraitement Hz (38), lequel pénètre dans le ou les éléments de structuration (18), de telle sorte qu'au moins dans la première couche ferromagnétique (116) des structures stratifiées adjacentes (100), des composantes de champ magnétique orientées différemment agissent comme champ magnétique de dispersion de l'élément de structuration (18) sous forme de champ d'épinglage M0 (60) qui s'étendent parallèlement à une surface de la structure stratifiée (100), sachant que le champ magnétique de prétraitement Hz (38) peut être couplé de préférence dans l'élément de structuration (18) perpendiculairement à la surface du substrat (110).

15. Procédé de fabrication d'un ensemble de structures stratifiées (100) selon l'une des revendications précédentes 1 à 13, comprenant les étapes : application des couches sur un substrat (110) dans l'ordre mentionné ou dans l'ordre inverse, entre une couche de recouvrement (128) et une couche d'ensemencement (112), réchauffement de la structure stratifiée (100) à une température supérieure à une température de blocage à laquelle le couplage d'échange entre la couche antiferromagnétique (114) et la première couche ferromagnétique (116) est supprimé, introduction d'un champ magnétique de prétraitement Hz (38) orienté en particulier perpendiculairement à la surface du substrat (110) dans les structures stratifiées (100) réchauffées pour un réglage simultané d'un champ d'épinglage M0 (60) avec des directions d'aimantation différentes d'au moins la première couche ferromagnétique (116) de structures stratifiées (110) adjacentes, au moins pendant une durée pour laquelle la température de la structure stratifiée (100) est supérieure à la température de blocage, et refroidissement de la structure stratifiée (100) à une température inférieure à une température de blocage.

16. Procédé selon la revendication 15, sachant que l'ensemble des structures stratifiées (100) est chauffé à au moins 260°C, de préférence 280°C, en particulier à au moins 300°C.

17. Procédé selon la revendication 15 ou 16, sachant que la densité de flux magnétique du champ magnétique de prétraitement couplé Hz (38) n'est pas supérieure à plus de 200 mT, de préférence à plus de 100 mT.

18. Procédé selon l'une de revendications 15 à 17, sachant qu'une durée pendant laquelle le champ magnétique de prétraitement Hz (38) est couplé dans la structure stratifiée (100) chauffée à une température supérieure à celle de blocage est d'au moins 1 h, de préférence d'au moins 5 h, tout particulièrement de préférence d'au moins 12 h.

19. Procédé de fabrication d'un capteur de champ magnétique magnétorésistif (10) selon la revendication 14, comprenant les étapes : fabrication de l'ensemble de structures stratifiées (100) conformément au procédé selon l'une des revendications 16 à 18, et application au moins temporaire de l'au moins un élément de structuration (18), sachant que le champ magnétique de prétraitement Hz (38) est couplé par l'intermédiaire de l'élément de structuration (18) sous la forme d'un champ d'épinglage M0 (60) dans les structures stratifiées (100) avec des directions d'aimantation différentes et à la suite de quoi, de préférence l'élément de structuration (18) est à nouveau retiré à la fin de l'épinglage.

20. Procédé selon la revendication 19, sachant que l'ensemble d'au moins deux structures stratifiées (100) adjacentes et espacées l'une de l'autre est appliqué sur le substrat (110) et que l'élément de structuration (18) est appliqué au moins temporairement entre les structures stratifiées (100), et sachant que le champ magnétique de prétraitement Hz (38) est couplé dans l'élément de structuration (18) perpendiculairement à la surface du substrat (110), de sorte qu'un champ magnétique de dispersion généré par l'élément de structuration (18) en tant que champ d'épinglage M0 (60) fournit principalement parallèle à la surface du substrat (110) une orientation divergente du champ d'épinglage M0 (60) de structures stratifiées (100) adjacentes, dont l'orientation dépend de la géométrie latérale de l'élément de structuration (18), de sorte que les orientations du champ d'épinglage (60) des structures stratifiées (100) adjacentes diffèrent les unes des autres, en particulier sont orientées essentiellement à l'opposé.

Fig. 1

Fig. 2a

Fig. 2b

Fig. 3

EP 3 918 356 B1

1/7

Fig. 4

Fig. 5

Fig. 6

Fig. 7a

Fig. 7b

Fig. 7c

Fig. 7d

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2016078793 A1
- WO 2016083420 A1
- US 20150213815 A1
- US 7505233 B2
- US 20170328963 A1
- US 20150318465 A1
- US 7605437 B2
- DE 112010003775 T5
- US 20180238972 A1

**In der Beschreibung aufgeführte Nicht-Patentliteratur**

- Spintronic Sensors. **FREITAS PAULO P et al.** PROCEEDINGS OF THE IEEE. IEEE, 01. Oktober 2016, vol. 104, 1894-1918